# EUROPEAN PATENT APPLICATION

(11) **EP 4 486 083 A1**
(43) Date of publication of application: **01.01.2025**
(21) Application number: 23859199.4
(22) Date of filing: 21.08.2023
(51) Int. Cl.: H05K 7/20

(54) **AIR CONDITIONING DEVICE**

(30) Priority: 27.08.2022 CN 202211035605; 27.08.2022 CN 202222281237 U; 27.08.2022 CN 202222281290 U; 27.08.2022 CN 202222280190 U
(71) Applicant: GD Midea Heating & Ventilating Equipment Co., Ltd., Foshan, Guangdong 528311 (CN); Hefei Midea Heating & Ventilating Equipment Co., Ltd., Hefei, Anhui 230088 (CN)
(72) Inventor: CHU, Guangpei, Foshan, Guangdong 528311 (CN); MA, Xihua, Foshan, Guangdong 528311 (CN); WANG, Mingren, Foshan, Guangdong 528311 (CN); WANG, Guochun, Foshan, Guangdong 528311 (CN); YI, Tengda, Foshan, Guangdong 528311 (CN); YANG, Yuantao, Foshan, Guangdong 528311 (CN); ZHANG, Tiegang, Foshan, Guangdong 528311 (CN); HUANG, Langshui, Foshan, Guangdong 528311 (CN); LUO, Huadong, Foshan, Guangdong 528311 (CN); HUANG, Junhao, Foshan, Guangdong 528311 (CN)
(74) Representative: RGTH
(86) International application number: PCT/CN2023/114123
(87) International publication number: WO 2024/046165

(57) **Abstract**

The present disclosure provides an air conditioner, which relates to the field of air conditioner technologies and is used for solving a technical problem that condensation generated by heat dissipation of an electronic element in an electronic control box (100) of the air conditioner easily causes failure and damage to the electronic element. The air conditioner includes a refrigerant flow path (400) and the electronic control box (100). The electronic control box (100) includes a box assembly (110), a circuit board assembly (140), a fan (130), and an evaporator (150). The evaporator (150) is connected to the refrigerant flow path (140) and configured to refrigerate by means of phase change of a refrigerant. The box assembly (110) has an accommodation cavity (101). The circuit board assembly (140), the fan (130), and the evaporator (150) are all disposed in the accommodation cavity (101). The fan (130) is configured to generate cooling airflow (500) in the accommodation cavity (101). The cooling airflow sequentially flows through the evaporator and the circuit board assembly to allow the cooling airflow refrigerated by the evaporator to dissipate heat from the circuit board assembly.

## Description

### CROSS-REFERENCE TO RELATED APPLICATION

This application claims a priority to Chinese Patent Application No. 202211035605.5, titled "AIR CONDITIONER", and filed with China National Intellectual Property Administration on August 27, 2022, Chinese Patent Application No. 202222281237.4, titled "AIR CONDITIONER", and filed with China National Intellectual Property Administration on August 27, 2022, Chinese Patent Application No. 202222281290.4, titled "AIR CONDITIONER", and filed with China National Intellectual Property Administration on August 27, 2022, Chinese Patent Application No. 202222280190.X, titled "AIR CONDITIONER", and filed with China National Intellectual Property Administration on August 27, 2022, the entire contents of which are incorporated herein by reference.

### FIELD

The present disclosure relates to the field of air conditioner technologies, and more particularly, to an air conditioner.

### BACKGROUND

The air conditioner, as a widely used temperature and humidity regulation equipment, usually comprises a compressor, an evaporator, a condenser, a fan, and other components, and generates a refrigerant flow circuit. The air conditioner is provided with an electronic control box to control operations of various components. The electronic control box is provided with an electrical element. The electrical element generates heat during operation, causing a high temperature occurred in the electronic control box. In related art, to lower a temperature of the electrical element and to ensure a heat dissipation effect, a refrigerant radiator is usually used to dissipate heat from the electrical element. However, refrigerants can easily cause the radiator and the electrical element to be overcooled, and generates condensation due to overcooling, resulting in a short circuit or damage to the electrical element, or even creating potential safety hazards.

### SUMMARY

An embodiment of the present disclosure is to provide an air conditioner, aiming to solve a technical problem that condensation generated by heat dissipation of an electronic element in the electronic control box of the air conditioner easily causes failure and damage to the electronic element.

To achieve the above embodiment, the present disclosure provides the air conditioner. The air conditioner comprises a refrigerant flow path and an electronic control box. The electronic control box comprises: a box assembly having an accommodation cavity; a circuit board assembly; a fan generating a cooling airflow in the accommodation cavity; and an evaporator connected to the refrigerant flow path and refrigerating by means of phase change of a refrigerant. Each of the circuit board assembly, the fan, and the evaporator is disposed in the accommodation cavity. The cooling airflow sequentially flows through the evaporator and the circuit board assembly. The cooling airflow refrigerated by the evaporator dissipates heat from the circuit board assembly.

The present disclosure has beneficial effects that the evaporator is arranged at the electronic control box and refrigerates airflow generated by the fan in the electronic control box, allowing the cooling airflow that has been cooled to be used for air-cooling heat dissipation of the circuit board assembly. In this way, on the one hand, it can be ensured that the circuit board assembly has a good heat dissipation effect, on the other hand, it can be avoided that the circuit board assembly produces condensation due to a local low temperature, which can ensure reliability of an electronic control.

### BRIEF DESCRIPTION OF THE DRAWINGS

FIG. 1 is a first schematic structural view of an electronic control box in an air conditioner according to an embodiment of the present disclosure.
FIG. 2 is a schematic view of an air conditioner according to an embodiment of the present disclosure.
FIG. 3 is a second schematic structural view of an electronic control box in an air conditioner according to an embodiment of the present disclosure.
FIG. 4 is a third schematic structural view of an electronic control box in an air conditioner according to an embodiment of the present disclosure.
FIG. 5 is a fourth schematic structural view of an electronic control box in an air conditioner according to an embodiment of the present disclosure.
FIG. 6 is a fifth schematic structural view of an electronic control box in an air conditioner according to an embodiment of the present disclosure.
FIG. 7 is a sixth schematic structural view of an electronic control box in an air conditioner according to an embodiment of the present disclosure.
FIG. 8 is a seventh schematic structural view of an electronic control box in an air conditioner according to an embodiment of the present disclosure.
FIG. 9 is an eighth schematic structural view of an electronic control box in an air conditioner according to an embodiment of the present disclosure.
FIG. 10 is a ninth schematic structural view of an electronic control box in an air conditioner according to an embodiment of the present disclosure.
FIG. 11 is a tenth schematic structural view of an electronic control box in an air conditioner according to an embodiment of the present disclosure.
FIG. 12 is an eleventh schematic structural view of an electronic control box in an air conditioner according to an embodiment of the present disclosure.
FIG. 13 is a twelfth schematic structural view of an electronic control box in an air conditioner according to an embodiment of the present disclosure.
FIG. 14 is a thirteen schematic structural view of an electronic control box in an air conditioner according to an embodiment of the present disclosure.
FIG. 15 is a fourteen schematic structural view of an electronic control box in an air conditioner according to an embodiment of the present disclosure.
FIG. 16 is a fifteen schematic structural view of an electronic control box in an air conditioner according to an embodiment of the present disclosure.
FIG. 17 is a schematic structural view of a heat exchanger assembly in an air conditioner according to an embodiment of the present disclosure.
FIG. 18 is an enlarged view of part B in FIG. 17;
FIG. 19 is a sixteen schematic structural view of an electronic control box in an air conditioner according to an embodiment of the present disclosure.
FIG. 20 is a schematic view of an arrangement in an electronic control box of an air conditioner according to an embodiment of the present disclosure.
FIG. 21 is a sectional view taken along line A-A of FIG. 19.
FIG. 22 is a schematic view of heat dissipation of a reactor by cooling airflow in an electronic control box in an air conditioner according to an embodiment of the present disclosure.
FIG. 23 is a schematic view of heat dissipation of a filter module by cooling airflow in an electronic control box in an air conditioner according to an embodiment of the present disclosure.
FIG. 24 is a seventeen schematic structural view of an electronic control box in an air conditioner according to an embodiment of the present disclosure.

### DETAILED DESCRIPTION OF THE EMBODIMENTS

In the related art, an electronic control box is generally disposed in an air conditioner to control operation of components such as a compressor and a fan. The electronic control box is provided with an electrical element generating heat during operation, causing a high temperature in the electronic control box. Therefore, heat dissipation of the electronic elements is required. To lower a temperature of the electronic element, the electronic control box can have an opening to be in communication with outside air. An airflow generated by the fan can be used to dissipate heat from the electronic elements. However, a heat dissipation effect is easily affected by an external environment. For example, when the external environment has a high temperature, the electronic element generates heat more seriously, and the heat dissipation effect is poor at this time. When the electronic element on the circuit board is dissipated by attaching a refrigerant pipe on a back of the circuit board, heat is absorbed by heat conduction using a refrigerant. However, the refrigerant easily causes a local temperature on a circuit board surface to be too low, and a temperature difference between other portions in the electronic control box and the circuit board surface is large. When hot air in the electronic control box encounters the circuit board with a too-low temperature, water molecules in the hot air easily form condensation on the circuit board surface, resulting in a short circuit or damage to the electronic element, and even creating safety hazards.

To this end, in embodiments of the present disclosure, an air duct is formed in the electronic control box, and an evaporator is disposed in the air duct. In addition, an airflow is generated by a fan. In this way, a temperature of the airflow can be lowered by the evaporator, and then the airflow that has been cooled can be used to dissipate heat from the electronic element. Therefore, an air-cooling airflow is not affected by the external environment, and has a good heat dissipation effect. Moreover, the local temperature on the circuit board surface should not be too low, which can avoid generating condensation and ensure operation reliability of the electronic element.

Technical solutions according to embodiments of the present disclosure will be described below in combination with accompanying drawings of the embodiments of the present disclosure. Obviously, the embodiments described below are only a part of the embodiments of the present disclosure, rather than all of the embodiments. On a basis of the embodiments in the present disclosure, all other embodiments obtained by a person skilled in the art without creative labor shall fall within the protection scope of the present disclosure.

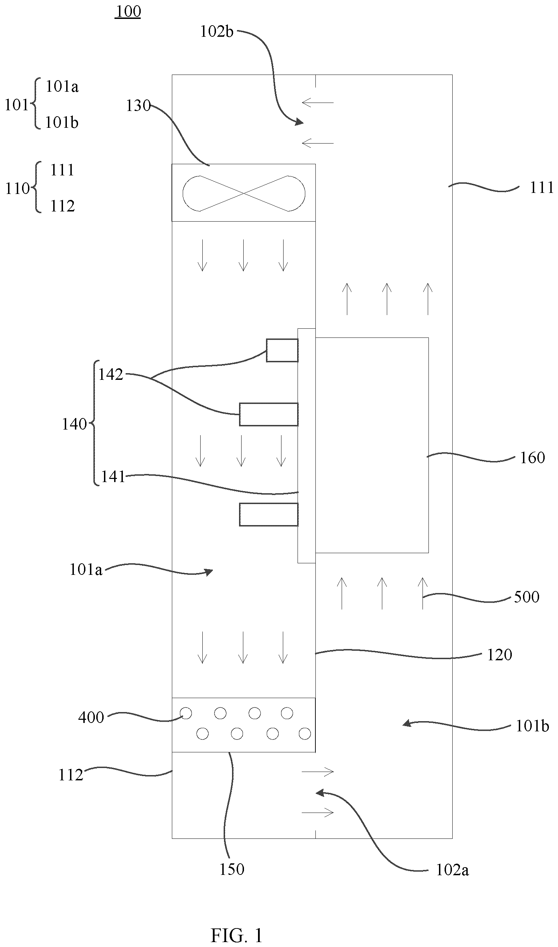

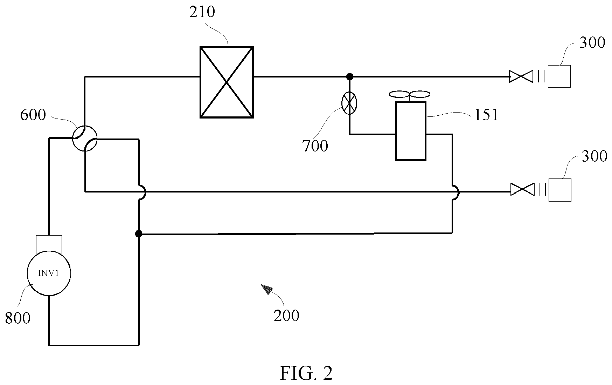

As shown in FIG. 1 and FIG. 2, this embodiment provides an electronic control box 100 of the air conditioner. The air conditioner further comprises a refrigerant flow path 400. The electronic control box 100 comprises a box assembly 110, a circuit board assembly 140, a fan 130, and an evaporator 150. The evaporator 150 is connected to the refrigerant flow path 400 and configured to refrigerate by means of phase change of a refrigerant. The box assembly 110 has an accommodation cavity 101. Each of the circuit board assembly 140, the fan 130, and the evaporator 150 is disposed in the accommodation cavity 101. The fan 130 is configured to generate a cooling airflow 500 in the accommodation cavity 101. The cooling airflow 500 sequentially flows through the evaporator 150 and the circuit board assembly 140, allowing the cooling airflow 500 refrigerated by the evaporator 150 to dissipate heat from the circuit board assembly 140.

When the fan 130 is started and operates, the cooling airflow 500 can be generated in the accommodation cavity 101, and can flow in the accommodation cavity 101 and sequentially through the evaporator 150 and the circuit board assembly 140. When the cooling airflow 500 flows through the evaporator 150 and the evaporator 150 is in operation, the evaporator 150 can refrigerate the cooling airflow 500 and absorb heat flowing through the cooling airflow 500 to reduce a temperature of the cooling airflow 500. Therefore, the temperature of the cooling airflow 500 can be lower than a surface temperature of the circuit board assembly 140 during operating. When the cooling airflow 500 flows through the circuit board assembly 140, the cooling airflow 500 can exchange heat with the circuit board assembly 140 to take away heat of the circuit board assembly 140, thereby lowering the temperature of the circuit board assembly 140 and achieving the heat dissipation effect.

It should be understood that when the electronic control box 100 is applied to the air conditioner, the circuit board assembly 140 is configured to control an operation of the air conditioner, for example, to control operation of the compressor, the fan, and the like in the air conditioner. In addition, the circuit board assembly 140 can control the operation of the fan 130 in the electronic control box 100.

It should be noted that the electronic control box 100 in the embodiments of the present disclosure is provided with the evaporator 150 which refrigerates the airflow generated by the fan 130 in the electronic control box 100, allowing the cooling airflow 500 that has been cooled to be used for air-cooling heat dissipation of the circuit board assembly 140. On the one hand, the cooling airflow 500 can be ensured not to be affected by the external environment. Under any operating condition, when the electronic control box 100 is operating and needs to dissipate heat, the temperature of the cooling airflow 500 can be lower than the surface temperature of the circuit board assembly 140. In this way, the cooling airflow 500 has a good air-cooling heat dissipation effect on the circuit board assembly 140. On the other hand, a low temperature of the evaporator 150 only affects air and airflow in the accommodation cavity 101, which can prevent the local temperature of the circuit board assembly 140 from being too low, to avoid the circuit board assembly 140 from generating condensation due to overcooling by utilizing the airflow that has been cooled to dissipating heat, thereby ensuring the circuit board assembly 140 to operate well.

In some embodiments, the evaporator 150 has an inlet connected to a low-pressure liquid refrigerant flow path of the refrigerant flow path 400 and an outlet connected to a low-pressure gaseous refrigerant flow path of the refrigerant flow path 400. The circuit board assembly 140 is located between an air outlet of the fan 130 and the evaporator 150, allowing the cooling airflow 500 to flow from the fan 130 to the evaporator 131 through the circuit board assembly 140.

It should be understood that the refrigerant flow path 400 in the air conditioner may be a circulation loop formed by sequentially connecting a compressor, an external heat exchanger, an expansion valve, and an internal heat exchanger in the air conditioner. The above components are connected through a pipeline for refrigerant circulation, and the air conditioner performs heat exchange by means of phase change in a circulation flow process of a refrigerant in the refrigerant flow path 400, thereby realizing a cooling or heating function. The evaporator 150 in the electronic control box 100 may be connected to a main flow path of the refrigerant flow path 400, or may be connected to a branch flow path of the refrigerant flow path 400, which is not specifically limited in this embodiment of the present disclosure.

In addition, the accommodation cavity 101 has a circulation air duct for unidirectional flow of the cooling airflow 500. The fan 130, the circuit board assembly 140, and the evaporator 150 are sequentially arranged at different positions in the circulation air duct at intervals in a flowing direction of the cooling airflow 500. The evaporator 131 is sealingly connected to an inner wall of the circulation air duct.

First, the flowing direction and path of the cooling airflow 500 and a structural layout in the accommodation cavity 101 will be described in detail.

Those skilled in the art should understand that the circuit board assembly 140 may comprise a circuit board 141 and a plurality of electrical elements 142. The plurality of electrical elements 142 is arranged at the circuit board 141 and electrically connected to form a circuit structure. When the circuit board assembly 140 operates, an electrical element 142 generates heat, and the heat is transferred to the circuit board 141. When the cooling airflow 500 flows through the circuit board assembly 140, a part of the heat can be removed by the electrical element 142 and the circuit board 141.

Referring to FIG. 1 and FIG. 2, to improve heat dissipation efficiency, a radiator 160 can be disposed in the electronic control box 100, and the radiator 160 may further be located in the accommodation cavity 101. The radiator 160 may be understood as an extension of a heat dissipation surface of the circuit board assembly 140 or a heat dissipation structure of the circuit board assembly 140. The heat of the circuit board assembly 140 may be transferred to the radiator 160 through heat conduction. When the cooling airflow 500 flows through the radiator 160, the heat may be efficiently removed, achieving a better heat dissipation effect.

For example, the radiator 160 may be relatively independent of the circuit board assembly 140. During assembling, the radiator 160 may be mounted at a side of the circuit board 141 away from the electrical element 142. Alternatively, the radiator 160 may be a derivative structure of the circuit board 141, and fixedly connected to the circuit board 141 or integrally formed with the circuit board 141, which is not specifically limited in the embodiments of the present disclosure.

It should be noted that the radiator 160 may occupy at least a partial cross-section of the circulation air duct in the flowing direction of the cooling airflow 500 to ensure the flowing the cooling airflow 500 has a sufficient contact area with the radiator 160 when passing through the radiator 160, thereby providing better heat dissipation effect.

In a possible implementation, the circuit board assembly 140 is located between the air outlet of the fan 130 and the evaporator 150, allowing the cooling airflow 500 to flow from the fan 130 to the evaporator 150 through the circuit board assembly 140. The radiator 160 is located between the evaporator 150 and the air inlet of the fan 130, allowing the cooling airflow 500 to flow from the evaporator 150 back to the fan 130 through the radiator 160.

It should be understood that after the fan 130 is started and operates, the cooling airflow 500 flows out from the air outlet of the fan 130. When the cooling airflow 500 passes through the circuit board assembly 140, the cooling airflow 500 performs a single air-cooling heat dissipation on the circuit board assembly 140. Thereafter, the cooling airflow 500 passes through the evaporator 150. In this case, the cooling airflow 500 performs heat exchange with the evaporator 150, and the evaporator 150 absorbs heat of the cooling airflow 500 to lower the temperature of the cooling airflow 500. The cooling airflow 500 that has been cooled will flow through the radiator 160 to fully dissipate heat from the radiator 160. Since the radiator 160 absorbs the heat of the circuit board assembly 140, the heat of the circuit board assembly 141 is correspondingly taken away at this time. Finally, the cooling airflow 500 returns to the air inlet of the fan 130 to complete a heat dissipation cycle, forming a circulating heat dissipation structure.

It should be noted that, in the embodiments of the present disclosure, the accommodation cavity 101 may be a sealed accommodation cavity. Correspondingly, the electronic control box 100 is a sealed electronic control box 100. When the cooling airflow 500 in the accommodation cavity 101 flows, the cooling airflow 500 will not convect with air outside the electronic control box 100. Therefore, external water vapor is difficult to enter the electronic control box 100, and water vapor content in the accommodation cavity 101 of the electronic control box 100 is limited. When the evaporator 150 absorbs heat and refrigerates the cooling airflow 500, the evaporator 150 also has a dehumidifying effect on the air. Therefore, condensation is difficult to be generated in the electronic control box 100.

Referring to FIG. 1, in a possible implementation, the electronic control box 100 according to the embodiments of the present disclosure may further comprise a separator 120 that is disposed in the accommodation cavity 101 and is connected to an inner wall of the accommodation cavity 101. The separator 120 and the inner wall of the accommodation cavity 101 together define the circulation air duct for the flowing of the cooling airflow 500. The circuit board assembly 140, the fan 130, and the evaporator 150 are located at different positions in the circulation air duct.

It should be understood that the circulation air duct defined by the separator 120 in the accommodation cavity 101 can not only provide space and layout positions for mounting the circuit board assembly 140, the radiator 160, the fan 130, and the evaporator 150, but also provide guidance for the flow of the cooling airflow 500. Therefore, a circulation flow of the cooling airflow 500 in the accommodation cavity 101 can be realized, allowing the temperature of the cooling airflow 500 to be maintained within a reasonable range and ensuring a good heat dissipation effect.

For example, the evaporator 131 is connected between the separator 120 and the inner wall of the accommodation cavity 101, and a specific mounting manner of the evaporator 131 is not specifically limited in the embodiments of the present disclosure.

In some embodiments, the separator 120 may divide the accommodation cavity 101 into a plurality of cavities that are connected to each other. Some of the plurality of cavities constitute a part of the circulation air duct, and the plurality of cavities is sequentially connected end-to-end to form a complete circulation air duct. The fan 130, the circuit board assembly 140, the evaporator 150, and the radiator 160 may be arranged in the plurality of cavities.

For example, the separator 120 may be connected to the box assembly 110 a by a fastener, such as a screw, a bolt, a bayonet, and the like, or the separator 120 may be connected to the box assembly 110 through welding. In addition, the separator 120 may be inserted into the accommodation cavity 101, and the inner wall of the accommodation cavity 101 has a guide groove for limiting. The embodiment of the present disclosure does not limit a specific connection manner between the separator 120 and the box assembly 110.

It should be understood by those skilled in the art that the separator 120 may divide the accommodation cavity 101 into a first cavity 101a and a second cavity 101b. The first cavity 101a and the second cavity 101b may be located at opposite sides of the separator 120, respectively. The first cavity 101a and the second cavity 101b can be connected, and the cooling airflow 500 may flow from the first cavity 101a to the second cavity 101b and may return from the second cavity 101b to the first cavity 101a.

One of two opposite ends of the separator 120 defines a first vent 102a together with the inner wall of the accommodation cavity 101, and another of two opposite ends of the separator 120 defines a second vent 102b together with the inner wall of the accommodation cavity 101. The first cavity 101a and the second cavity 101b are connected end-to-end through the first vent 102a and the second vent 102b to form the circulation air duct, which is beneficial to an arrangement of the fan 130, the evaporator 150, and the circuit board assembly 140 in the accommodation cavity 101, thereby ensuring the smoothness of the flow of the cooling airflow 500 and improving a space utilization rate in the accommodation cavity 101.

For example, after the cooling airflow 500 flows in the first cavity 101a, the cooling airflow 500 may flow from the second vent 102b to the second cavity 101b, and after the cooling airflow 500 flows in the second cavity 101b, the cooling airflow 500 may flow back from the first vent 102a to the first cavity 101a, thus forming a circulating cooling airflow 500.

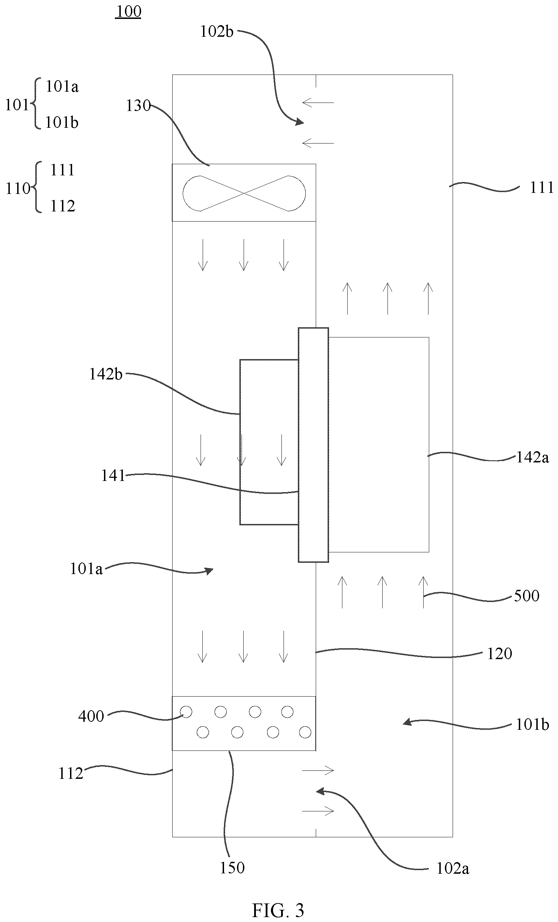

Referring to FIG. 3, in some embodiments, the circuit board assembly 140 may comprise a first circuit module 142a and a second circuit module 142b. Power of the first circuit module 142a is greater than power of the second circuit module 142b. One of the first circuit module 142a and the second circuit module 142b is located in the first cavity 101a, and another of the first circuit module 142a and the second circuit module 142b is located in the second cavity 101b. The cooling airflow sequentially flows through the evaporator 150, the first circuit module 142a, and the second circuit module 142b.

It should be understood that, during a normal operation of the air conditioner, a heat generation amount of the first circuit module 142a is greater than a heat generation amount of the second circuit module 142b. The cooling airflow that has been cooled through the evaporator 150 can first flow through the first circuit module 142a with greater heat generation amount, allowing the cooling airflow to preferentially take away heat of the first circuit module 142a, thereby providing a better heat dissipation effect on the first circuit module 142a with greater heat generation amount.

In a possible implementation, the radiator 160 and the circuit board assembly 140 may be located at different sides of the separator 120. The radiator 160 is constructed to dissipate heat from the circuit board assembly 140 through heat conduction. Therefore, the heat of the circuit board assembly 140 can be conducted by utilizing the radiator 160, and an area of effective air-cooling heat dissipation for the circuit board assembly 140 can be increased, thereby improving the heat dissipation efficiency

It should be understood that the radiator 160 may be located in one of the first cavity 101a and the second cavity 101b, and the circuit board assembly 140 may be located in another of the first cavity 101a and the second cavity 101b. When the cooling airflow 500 passes through the first cavity 101a and the second cavity 101b, the circuit board assembly 140 and the radiator 160 can be subjected to air-cooling heat dissipation, respectively.

For example, the circuit board assembly 140 may be mounted at a side of the separator 120 facing the first cavity 101a, i.e., the circuit board assembly 140 may be located in the first cavity 101a. The radiator 160 may be mounted at a side of the separator 120 facing the second cavity 101b, i.e., the radiator 160 may be located in the second cavity 101b. The separator 120 may have an opening, allowing the circuit board assembly 140 and the radiator 160 to contact through the opening, thereby realizing heat conduction from the circuit board assembly 140 to the radiator 160.

It should be noted that the circuit board assembly 140 and the radiator 160 are located at different positions in the circulation air duct. When passes through the radiator 160, the cooling airflow 500 can fully contact the radiator 160, thereby improving the heat dissipation efficiency.

In some embodiments, the radiator 160 may have a plurality of heat dissipation fins arranged at intervals. Gaps are formed between the heat dissipation fins to allow the airflow to flow. When the cooling airflow 500 flows through the gaps between the heat dissipation fins, heat of the heat dissipation fins can be taken away, and a contact area between the cooling airflow 500 and the heat dissipation fins is increased.

In other embodiments, the radiator 160 may have a heat dissipation channel. The heat dissipation channel may extend in the flowing direction of the cooling airflow 500, and the cooling airflow 500 may pass through the radiator 160 through the heat dissipation channel. When the cooling airflow 500 contacts an inner wall of the heat dissipation channel, heat of the radiator 160 may be taken away, which may not only ensure the heat dissipation effect, but also guide a flow of the cooling airflow 500.

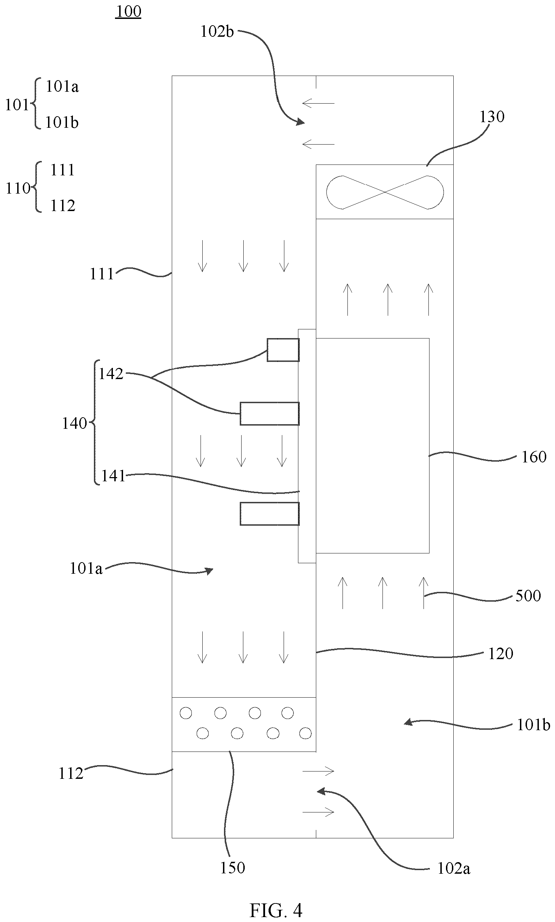

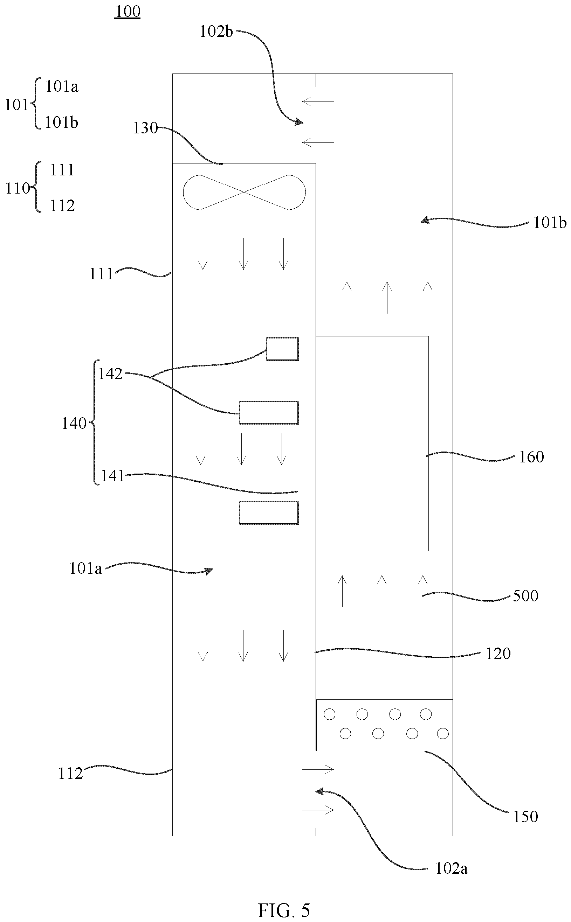

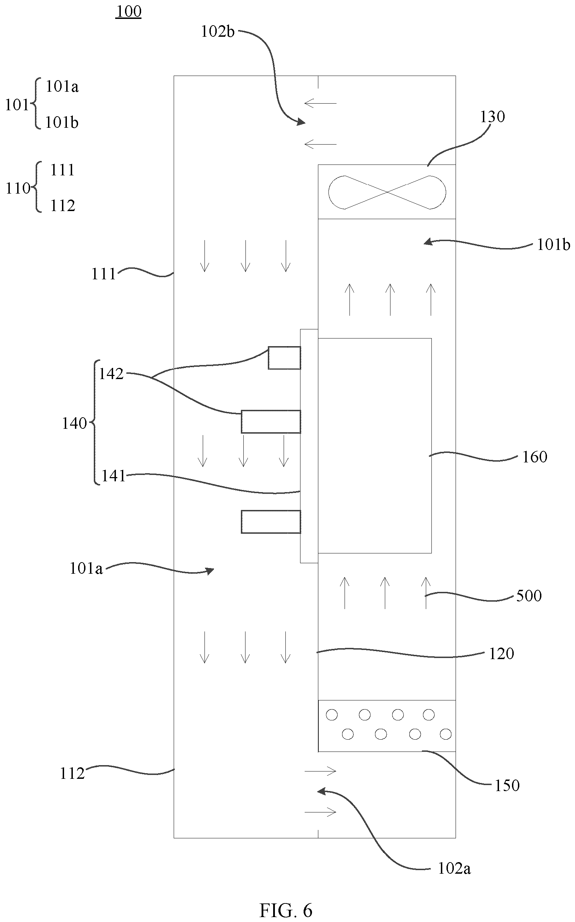

FIG. 3 is a second schematic structural view of the electronic control box in the air conditioner according to an embodiment of the present disclosure. FIG. 4 is a third schematic structural view of the electronic control box in the air conditioner according to an embodiment of the present disclosure. FIG. 5 is a fourth schematic structural view of the electronic control box in the air conditioner according to an embodiment of the present disclosure. FIG. 6 is a fifth schematic structural view of the electronic control box in the air conditioner according to an embodiment of the present disclosure.

Referring to FIG. 1 to FIG. 6, in a possible implementation, the fan 130 and the evaporator 150 are located at two ends of the separator 120, respectively, or the fan 130 and the evaporator 150 are located at one end of the separator 120. When the cooling airflow 500 circulates, upstream and downstream positions of the circuit board assembly 140 relative to the cooling airflow 500 can be controlled by arranging positions of the fan 130 and the evaporator 150. The circuit board assembly 140 as a whole is ensured to have a better heat dissipation effect.

When the fan 130 and the evaporator 150 are located at the two ends of the separator 120, respectively. The fan 130 may be located at a side of the second vent 102b and the evaporator 150 may be located at a side of the first vent 102a.

Referring to FIG. 1, for example, the fan 130 may be located at a side of the second vent 102b facing the first cavity 101a. The evaporator 150 may be located at a side of the first vent 102a facing the first cavity 101a. The cooling airflow 500 flows from the fan 130 to the circuit board assembly 140 and from the circuit board assembly 140 to the evaporator 150. The cooling airflow 500 enters the second cavity 101b through a first vent hole, and then flows through the radiator 160. Next, the cooling airflow 500 returns from the second vent 102b to the first cavity 101a, i.e., returns to an air inlet side of the fan 130, completing the circulation of the cooling airflow 500.

Referring to FIG. 4, for example, the fan 130 may be located at a side of the second vent 102b facing the second cavity 101b. The evaporator 150 may be located at a side of the first vent 102a facing the first cavity 101a. The cooling airflow 500 flows from the fan 130 to the first cavity 101a through the second vent 102b. Then the cooling airflow 500 flows through the circuit board assembly 140, and flows from the circuit board assembly 140 to the evaporator 150. Next, the cooling airflow 500 enters the second cavity 101b through the first vent hole. Finally, the cooling airflow 500 flows through the radiator 160, and returns to the air inlet side of the fan 130, completing the circulation of the cooling airflow 500.

Referring to FIG. 5, for example, the fan 130 may be located at the side of the second vent 102b facing the first cavity 101a. The evaporator 150 may be located at a side of the first vent 102a facing the second cavity 101b. The cooling airflow 500 flows from the fan 130 to the circuit board assembly 140, then enters the second cavity 101b through the first vent hole. Then, the cooling airflow 500 flows through the evaporator 150, and flows from the evaporator 150 to the radiator 160. Next, the cooling airflow 500 returns from the second vent 102b to the first cavity 101a, i.e., returns to the air inlet side of the fan 130, completing the circulation of the cooling airflow 500.

Referring to FIG. 6, for example, the fan 130 may be located at the side of the second vent 102b facing the second cavity 101b. The evaporator 150 may be located at the side of the first vent 102a facing the second cavity 101b. The cooling airflow 500 flows from the fan 130 to the first cavity 101a through the second vent 102b. Then the cooling airflow 500 flows through the circuit board assembly 140, and enters the second cavity 101b through the first vent hole. Next, the cooling airflow 500 flows through the evaporator 150, and flows from the evaporator 150 to the radiator 160. Finally, the cooling airflow 500 passes through the radiator 160 and returns to the air inlet side of the fan 130, completing the circulation of the cooling airflow 500.

It should be noted that the positions of the fan 130 and the evaporator 150 can be reversed, that is, the evaporator 150 can be disposed at the side of the second vent 102b, and the fan 130 can be disposed at the side of the first vent 102a, which is not described here.

When the fan 130 and the evaporator 150 are located at one end of the separator 120, the evaporator 150 and the fan 130 may be located at opposite sides of the first vent 102a or the second vent 102b, respectively.

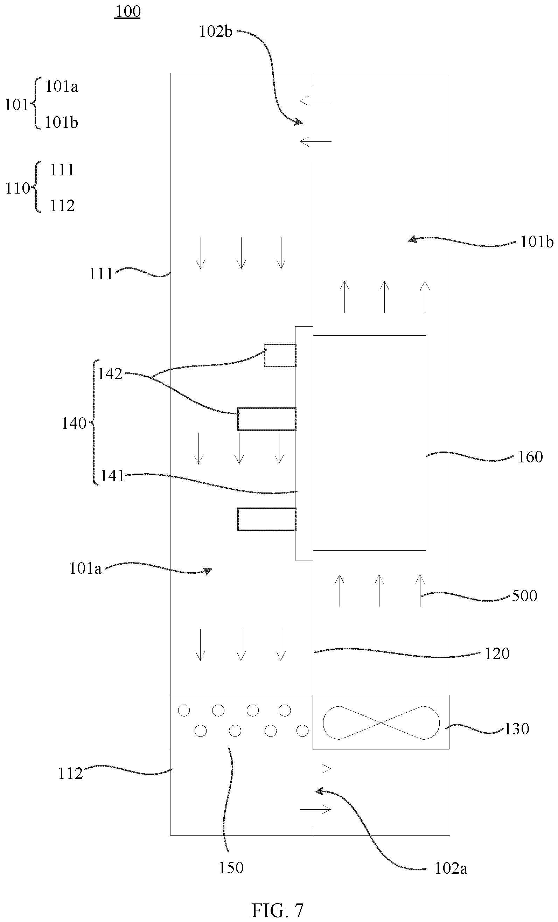

Referring to FIG. 7, for example, the evaporator 150 is located at the side of the first vent 102a facing the first cavity 101a. The fan 130 is located at the side of the first vent 102a facing the second cavity 101b. After the cooling airflow 500 flows out of the fan 130, first passes through the radiator 160, then enters the first cavity 101a from the second vent 102b. Then the cooling airflow 500 flows through the circuit board assembly 140 in the first cavity 101a, and passes through the evaporator 150. Thereafter, the cooling airflow 500 flows from the first vent 102a to the second cavity 101b, i.e., returns to the air inlet side of the fan 130, completing the circulation of the cooling airflow 500.

Referring to FIG. 1, in a possible implementation, the separator 120 may be of a shape of a plate, and the separator 120 may be arranged in the accommodation cavity 101 in a length direction of the accommodation cavity 101 to allow the first cavity 101a and the second cavity 101b to be arranged side by side in a width direction of the accommodation cavity 101, thereby facilitating the fan 130, the radiator 160, the circuit board assembly 140, the evaporator 150 being arranged in the first cavity 101a and the second cavity 101b and left and right sides and on the left and right sides, respectively. Therefore, the rationality of space allocation is improved.

It should understood that the separator 120 may extend in a vertical direction. The cooling airflow 500 may flow in the vertical direction in the first cavity 101a and the second cavity 101b. A flowing direction of the cooling airflow 500 in the first cavity 101a is opposite to a flowing direction of the cooling airflow 500 in the second cavity 101b, thereby improving the smoothness of the flow of the cooling airflow 500.

For example, the cooling airflow 500 may flow from top to bottom in the first cavity 101a, i.e., from the second vent 102b to the first vent 102a. After entering the second cavity 101b from the first vent 102a, the cooling airflow 500 may flow from bottom to top, i.e., from the first vent 102a to the second vent 102b, and flows from the second vent 102b back to the first cavity 101a.

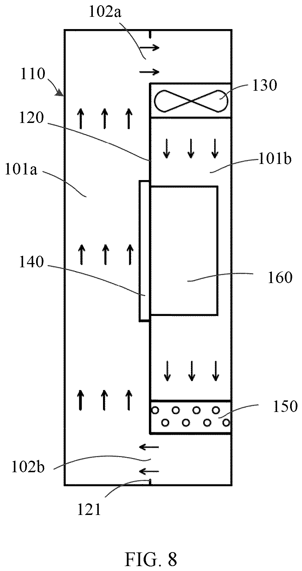

Referring to FIG. 8 to FIG. 11, in the air conditioner according to the embodiments of the present disclosure, an airflow circulation channel is formed inside the box assembly 110. The fan 130, the circuit board assembly 140, and the evaporator 150 are arranged in the airflow circulation channel at intervals and located at different positions in an airflow circulation direction. The fan 130 is configured to drive air to circulate unidirectionally in the air circulation channel, and an outflow side of the fan 130 faces the evaporator 150. Therefore, the airflow delivered by the fan 130 refrigerates the circuit board assembly 140 after passing through the evaporator 150.

Under an action of the fan 130, air in the box assembly 110 is driven to circulate unidirectionally in the airflow circulation channel, allowing the air passing through the circuit board assembly 140 and taking away the heat dissipated by circuit board assembly 140. The airflow is refrigerated by the evaporator 150, and the refrigerant flows through the evaporator 150. Heat of the airflow passing through the evaporator 150 is absorbed by means of the phase change of the refrigerant. Therefore, the air passing through the evaporator 150 is refrigerated to become the cooling airflow. The cooling airflow refrigerates and dissipates heat for the circuit board assembly 140. Therefore, in a process of airflow circulation, circulating heat dissipation is realized, and the heat dissipation effect is improved, which avoids an influence of high temperature on an operation of the circuit board assembly 140 and provides a guarantee for the normal operation of the air conditioner.

The box assembly 110 is outside sealed and internally has the first cavity 101a and a second cavity 101b. The first cavity 101a and the second cavity 101b are connected through the first vent 102a and the second vent 102b to form an airflow circulation channel. Due to outside sealing of the box assembly 110, an influence of factors such as ambient temperature and humidity on the heat dissipation effect of the electronic control box can be effectively lowered.

In a possible implementation, the airflow circulation channel is a unidirectional circulation channel, and the fan 130 is configured to drive air to flow unidirectional in the airflow circulation channel.

The fan 130, the evaporator 150, and the circuit board assembly 140 are sequentially arranged at intervals in the airflow circulation channel in the airflow circulation direction. The fan 130 is configured to drive air in the airflow circulation channel to circulate unidirectionally, and the outflow side of the fan 130 faces the evaporator 150. The airflow delivered by the fan 130 sequentially passes through the evaporator 150 and the circuit board assembly 140 and circulates, allowing the airflow refrigerated by the evaporator 150 to flow to the circuit board assembly 140 and refrigerate the circuit board assembly 140.

In a possible implementation, the inlet of the evaporator 150 is connected to the low-pressure liquid refrigerant flow path 400 in the refrigerant flow path 400, and the outlet of the evaporator 150 is connected to the low-pressure gaseous refrigerant flow path 400 in the refrigerant flow path 400. That is, the evaporator 150 is connected in series with the refrigerant flow path 400, which allows a low-pressure liquid refrigerant to flow to the evaporator 150 for evaporation and heat exchange. In this way, the low-pressure liquid refrigerant in the low-pressure liquid refrigerant flow path 400 performs a phase change in the evaporator 150, and becomes a low-pressure gaseous refrigerant. Then the low-pressure gaseous refrigerant flows out through the low-pressure gaseous refrigerant flow path 400.

It is easy to understand that the outflow side of the fan 130 faces the evaporator 150, that is, the airflow delivered by the fan 130 flows towards the evaporator 150, and the fan 130 can directly blow air towards the evaporator 150 to increase an airflow speed.

In some embodiments, the box assembly 110 internally has the separator 120. The first cavity 101a and the second cavity 101b are separated by the separator 120. The first vent 102a is located at one end of the separator 120, and the second vent 102b is located at another end of the separator 120.

The box assembly 110 may be not limited to a cubic shape, a cylindrical shape, a polygonal prism shape, or the like, and may be of other shapes. A shape of the separator 120 matches a shape of the box assembly 110. The separator 120 separates the first cavity 101a and the second cavity 101b to allow airflow to flow between the first cavity 101a and the second cavity 101b only through the first vent 102a and the second vent 102b.

In a possible implementation, the first cavity 101a and the second cavity 101b are arranged side by side in a horizontal direction, the separator 120 extends in the vertical direction. The first vent 102a is located at a first end of the separator 120, and the second vent 102b is located at a second end of the separator 120. The second end is opposite to the first end. The first end may be located at a top of the separator 120 and the second end may be located at a bottom of the separator 120, or the first end may be located at a bottom of the separator 120 and the second end may be located at a top of the separator 120.

In another possible implementation, the first cavity 101a and the second cavity 101b are arranged side by side in the vertical direction, and the separator 120 extends in the horizontal direction. The first vent 102a is located at the first end of the separator 120, and the second vent 102b is located at the second end of the separator 120. The second end is opposite to the first end. The first end may be located at one end in a width direction of the separator 120, and the second end may be located at another end in the width direction of the separator 120.

In a possible implementation, the first vent 102a may be a rectangular vent, a circular vent, an elliptical vent, a polygonal vent, etc. The first vent 102a may be one or a plurality of first vents 102a evenly arranged to allow the airflow to pass through. The second vent 102b may be a rectangular vent, a circular vent, an elliptical vent, a polygonal vent, etc. The second vent 102b may be one or a plurality of second vents 102b evenly arranged to allow the airflow to pass through. It is easy to understand that a shape of the second vent 102b may be the same as or different from a shape of the first vent 102a, and is not specifically limited herein.

To prevent air circulating in the air circulation channel from encountering the evaporator 150 to form condensed water and dropping to the circuit board assembly 140, a mounting height of the circuit board assembly 140 relative to the box assembly 110 is higher than a mounting height of the evaporator 150 relative to the box assembly 110 in the vertical direction. That is, the mounting height of the circuit board assembly 140 is higher than the mounting height of the evaporator 150. Therefore, the evaporator 150 is lower than the circuit board assembly 140, improving the use safety of the air conditioner.

In a possible implementation, the separator 120 is of the shape of the plate and extends in a length direction of the box assembly 110. That is, in the length direction of the box assembly 110, two ends of the separator 120 are sealingly connected to an inner wall of the box assembly 110, respectively.

For example, the separator 120 may be a baffle, and the separator 120 may be connected to the inner wall of the box assembly 110 through welding.

In a possible implementation, the second vent 102b may be a through hole penetrating through two surfaces of the separator 120. When the first cavity 101a and the second cavity 101b are arranged side by side in the vertical direction, a resist portion 121 is formed at the bottom of the separator 120. The resist portion 121 may separate a bottom of the first cavity 101a from a bottom of the second cavity 101b.

In a possible implementation, the evaporator 150 is sealingly connected to an inner wall of the air circulation channel, which is beneficial for airflow flowing through the evaporator 150 to disperse and circulate through gaps between pipes inside the evaporator 150, allowing more air in the airflow circulation channel to contact a surface of the evaporator 150. In this way, the heat exchange efficiency and the heat dissipation effect can be improved.

In a possible implementation, the electronic control box according to the present disclosure further comprises the radiator 160. The radiator 160 is disposed between the fan 130 and the evaporator 150. The fan 130, the radiator 160, the evaporator 150, and the circuit board assembly 140 are arranged in order in a flowing direction of the airflow in the airflow circulation channel. One of the radiator 160 and the circuit board assembly 140 is located in the first cavity 101a and another of the radiator 160 and the circuit board assembly 140 is located in the second cavity 101b. That is, the radiator 160 may be located in the first cavity 101a, and the circuit board assembly 140 may be located in the second cavity 101b. Alternatively, the radiator 160 may be located in the second cavity 101b, and the circuit board assembly 140 may be located in the first cavity 101a.

For example, the circuit board assembly 140 and the radiator 160 are connected to opposite sides of the separator 120, respectively. The circuit board assembly 140 is not limited to being disposed at the separator 120 in a manner of a screw connection or a snap connection.

The circuit board assembly 140 comprises a circuit board and an electronic component disposed at the circuit board. The circuit board assembly 140 is disposed at the separator 120. The circuit board assembly 140 may be connected to a corresponding component outside the box assembly 110 through a cable, thereby transmitting an electrical signal.

The evaporator 150 is connected between the separator 120 and the inner wall of the box assembly 110 to block the air circulation channel between the fan 130 and the circuit board assembly 140.

In a possible implementation, the fan 130 and the evaporator 150 are located at opposite ends of the separator 120.

In another possible implementation, the fan 130 and the evaporator 150 are located at the first end and second end of separator 120, respectively.

One or more evaporators 150 may be provided. The evaporator 150 may be a stand-alone monolithic structure for ease of mounting and removal. The refrigerant performs the phase change in the evaporator 150 to generate the cooling airflow in the box assembly 110, and the cooling airflow is utilized to dissipate heat from the circuit board assembly 140. Therefore, condensation due to overcooling of the circuit board assembly 140 can be avoided, and the normal operation of the circuit board assembly 140 can be ensured.

In a possible implementation, the radiator 160 is the heat dissipation fin. The plurality of heat radiation fins may be provided, and a number of heat radiation fins is not specifically limited. The heat radiation fin may not be limited to a rectangular shape, and may also be a triangular shape, etc.

The heat dissipation fin may extend in a direction perpendicular to the separator 120, or may extend in a direction inclined towards the separator 120. Heat is transferred through the heat dissipation fin. The plurality of heat dissipation fins may be arranged in a plurality of rows and a plurality of columns. Such a structure enables airflow to pass through a gap between two adjacent rows of heat dissipation fins, and take away heat conducted to the heat dissipation fins by the circuit board assembly 140, thereby facilitating heat dissipation. The heat dissipation fin is not limited to aluminum or copper.

In unit time, heat absorption of the evaporator 150 is greater than or equal to heat generation of the circuit board assembly 140 during operation. In this way, a stable heat dissipation effect can be ensured, and the heat dissipation effect is basically not affected by the external environment. During operation, the circuit board assembly 140 can be effectively refrigerated and dissipated, preventing high temperature due to prolonged operation time, which results in the heat dissipation effect of the circuit board assembly 140 not being guaranteed.

It should be noted that a temperature of the cooling airflow formed after the cooling airflow 500 flows through the evaporator 150 is lower than the surface temperature of the circuit board assembly 140, thereby ensuring the heat dissipation and cooling effect of the circuit board assembly 140.

In a possible implementation, the box assembly 110 is in a shape of a cube. The box assembly 110 may be provided with a bottom plate at a bottom of the box assembly 110, a top plate at a top of the box assembly 110, and four sealing plates connected end-to-end and at a periphery of the box assembly 110. A top end of the sealing plate is connected to the top plate, and a bottom end of the sealing plate is connected to the bottom plate, realizing sealing of the periphery of the box assembly 110. Of course, the box assembly 110 may further comprise a cubic skeleton. The bottom of the box assembly 110 has the bottom plate, the top of the box assembly 110 has the top plate. The periphery of the box assembly 110 has sealing plates. The bottom plate is fixed to a bottom surface of the cubic skeleton, and the top plate is fixed to a top surface of the cubic skeleton. The sealing plates are fixed to a peripheral surface of the cubic skeleton. Therefore, peripheral sealing of the box assembly 110 is realized.

In addition, a space in the box assembly 110 is completely closed. Therefore, dust, gravel, insects, and other living organisms can be effectively isolated from the external environment, ensuring that the airflow circulation channel has a good dustproof and sand-proof effect, and also preventing insects and other living organisms from entering and affecting the normal operation of the circuit board assembly 140.

According to the electronic control box of the present disclosure, the periphery of the box assembly 110 is sealed. Therefore, the electronic control box can cope with severe environments, and can effectively prevent rainwater from entering. In addition, the electronic control box can well avoid problems such as corrosion, circuit failure, and the like caused by rainwater entering when operating in a rainy or wet operating environment. Therefore, the normal operation of the air conditioner and a service life of electronic components in the circuit board assembly 140 can be ensured.

Referring to FIG. 8, in some embodiments, the box assembly 110 internally has the first cavity 101a and the second cavity 101b. The first cavity 101a and the second cavity 101b are arranged from left to right. The first vent 102a is located at the top of the separator 120, and the second vent 102b is located at the bottom of the separator 120.

The circuit board assembly 140 is located in the first cavity 101a. The fan 130 is located in the second cavity 101b, and the fan 130 is close to the first vent 102a. The radiator 160 is located in the second cavity 101b. The evaporator 150 is located in the second cavity 101b, and the evaporator 150 is close to the second vent 102b. The radiator 160 is opposite to the circuit board assembly 140. The radiator 160 and the circuit board assembly 140 are located in a middle position in a height direction of the separator 120. Heat dissipated by the electronic component in the circuit board assembly 140 during operation may be conducted directly to the radiator 160 for heat dissipation, or may be conducted by means of heat exchange and heat dissipation through the cooling air circulating in the first cavity 101a.

In this structure, the airflow delivered by the fan 130 is directly blown to the radiator 160, which is beneficial to speed up airflow passing through a surface of the radiator 160 and improve heat exchange efficiency of the radiator 160. The airflow passing through the radiator 160 flows to the evaporator 150 and exchanges heat with a refrigerant circulating in the evaporator 150 to refrigerate the airflow, thereby generating the cooling airflow. The cooling airflow is then delivered to the first cavity 101a through the second vent 102b, allowing the heat dissipated by the electronic component in the circuit board assembly 140 during operation to be carried away. In this way, the temperature of the cooling airflow is raised, and then the cooling airflow is transferred to the second cavity 101b through the first vent 102a to reciprocate, which can realize the airflow circulation. Heat exchange is performed between the cooling airflow and the electronic component in the circuit board assembly 140, achieving heat dissipation and temperature reduction for the circuit board assembly 140. The circuit board assembly 140 is prevented from overcooling and generating condensation, which ensures the normal operation of the circuit board assembly 140.

In this embodiment, since the evaporator 150 is located below the radiator 160, and airflow after absorbing the heat of the radiator 160 can be directly blown to the evaporator 150 by the fan 130, which helps to improve the heat exchange efficiency, thereby improving the heat dissipation effect of the electronic control box.

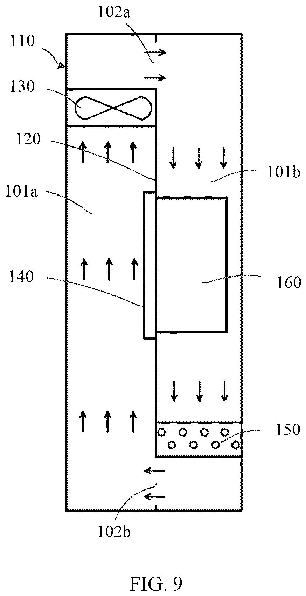

Referring to FIG. 9, in some embodiments, the box assembly 110 internally has the first cavity 101a and the second cavity 101b. The first cavity 101a and the second cavity 101b are arranged from left to right. The first vent 102a is located at the top of the separator 120, and the second vent 102b is located at the bottom of the separator 120.

The circuit board assembly 140 is located in the first cavity 101a. The fan 130 is disposed in the first cavity 101a, and the fan 130 is close to the first vent 102a. The radiator 160 is located in the second cavity 101b. The evaporator 150 is disposed in the second cavity 101b, and the evaporator 150 is close to the second vent 102b. The radiator 160 is opposite to the circuit board assembly 140. The radiator 160 and the circuit board assembly 140 are located in the middle position in the height direction of the separator 120. The heat dissipated by the electronic component in the circuit board assembly 140 during operation may be conducted directly to the radiator 160 for heat dissipation, or may be conducted by means of heat exchange and heat dissipation through the cooling air circulating in the first cavity 101a.

In this structure, the fan 130 sucks airflow in the first cavity 101a upward, which is beneficial for the airflow refrigerated by the evaporator 150 to flow more strongly to the circuit board assembly 140 to take away the heat dissipated by the electronic component in the circuit board assembly 140 during operation, thereby improving the heat exchange effect between the electronic component in the circuit board assembly 140 and the airflow in the first cavity 101a. The airflow that takes away the heat dissipated by the electronic component in the circuit board assembly 140 during operation enters the second cavity 101b from the first vent 102a, and exchanges heat with the radiator 160 again. The airflow finally flows to the surface of the evaporator 150, and exchanges heat with the refrigerant circulating in the evaporator 150 to refrigerate the airflow. A hot airflow becomes the cooling airflow. The cooling airflow is then delivered to the first cavity 101a through the second vent 102b and thus reciprocates to achieve the airflow circulation. Heat exchange is performed between the cooling airflow and the electronic component in the circuit board assembly 140, achieving heat dissipation and temperature reduction for the circuit board assembly 140. The circuit board assembly 140 is prevented from overcooling and generating condensation, which ensures the normal operation of the circuit board assembly 140.

In this embodiment, since the cooling airflow after heat exchange with the refrigerant circulating in the evaporator 150 is directly sucked upward by the fan 130, the airflow flow is stronger. The heat exchange efficiency between the cooling airflow and the electronic component in the circuit board assembly 140 is improved, and the heat dissipation effect is improved.

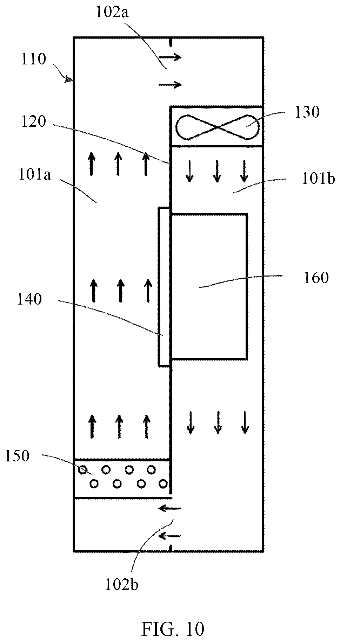

Referring to FIG. 10, in some embodiments, the box assembly 110 internally has the first cavity 101a and the second cavity 101b. The first cavity 101a and the second cavity 101b are arranged from left to right. The first vent 102a is located at the top of the separator 120, and the second vent 102b is located at the bottom of the separator 120.

The circuit board assembly 140 is located in the first cavity 101a. The fan 130 is located in the second cavity 101b, and the fan 130 is close to the first vent 102a. The radiator 160 is located in the second cavity 101b. The evaporator 150 is located in the first cavity 101a, and the evaporator 150 is close to the second vent 102b. The radiator 160 is opposite to the circuit board assembly 140. The radiator 160 and the circuit board assembly 140 are located in the middle position in the height direction of the separator 120. The heat dissipated by the electronic component in the circuit board assembly 140 during operation may be conducted directly to the radiator 160 for heat dissipation, or may be conducted by means of heat exchange and heat dissipation through the cooling air circulating in the first cavity 101a.

In this embodiment, since the airflow delivered by the fan 130 is directly blown to the radiator 160, which is beneficial to speed up the airflow passing through the surface of the radiator 160 and improve the heat exchange efficiency of the radiator 160, and thus improving the heat dissipation effect.

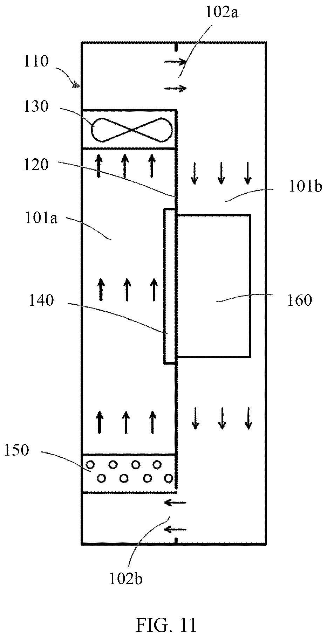

Referring to FIG. 11, in some embodiments, the box assembly 110 internally has the first cavity 101a and the second cavity 101b. The first cavity 101a and the second cavity 101b are arranged from left to right. The first vent 102a is located at the top of the separator 120, and the second vent 102b is located at the bottom of the separator 120.

The circuit board assembly 140 is located in the first cavity 101a. The fan 130 is located in the first cavity 101a and is close to the first vent 102a. The radiator 160 is located in the second cavity 101b. The evaporator 150 is located in the first cavity 101a and is close to the second vent 102b. The radiator 160 and the circuit board assembly 140 are opposite to each other and are located at the middle position in the height direction of the separator 120. The heat dissipated by the electronic component in the circuit board assembly 140 during operation may be conducted directly to the radiator 160 for heat dissipation, or may be conducted by means of heat exchange and heat dissipation through the cooling air circulating in the first cavity 101a.

In this embodiment, since the airflow refrigerated by the evaporator 150 is directly blown to the circuit board assembly 140 under an air suction effect of the fan 130, which is beneficial to speed up the airflow passing through a surface of the circuit board assembly 140, and improve the heat exchange efficiency of the circuit board assembly 140, thus improving the heat dissipation effect.

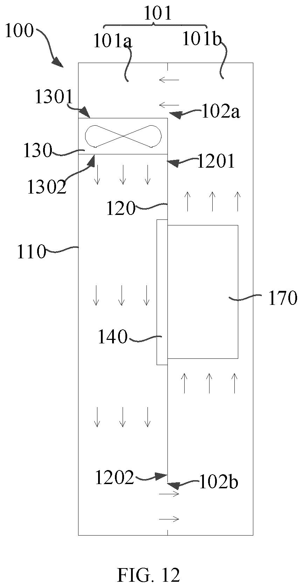

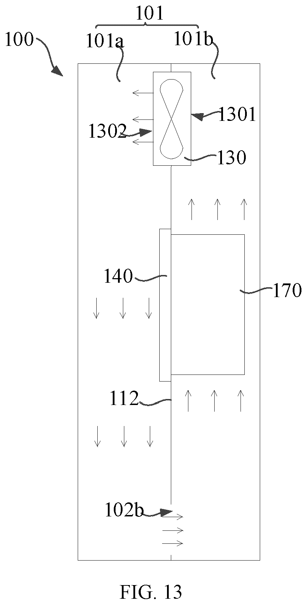

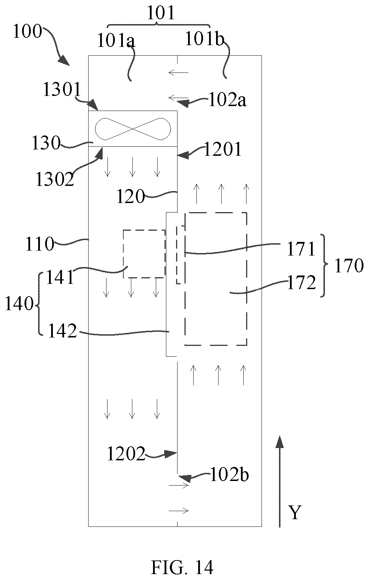

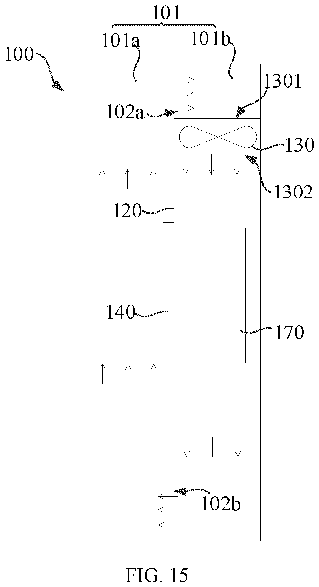

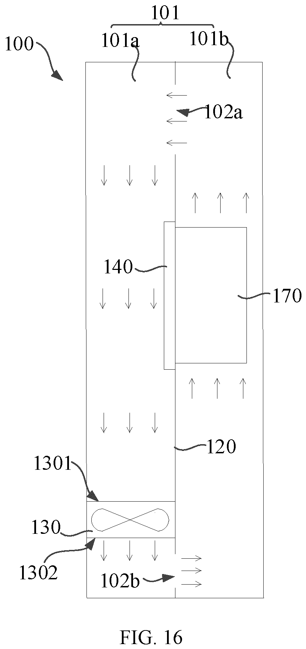

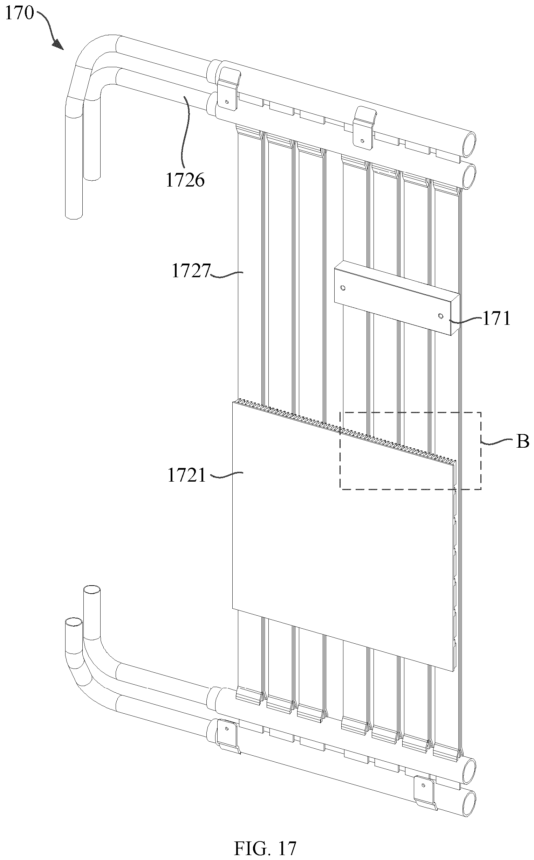

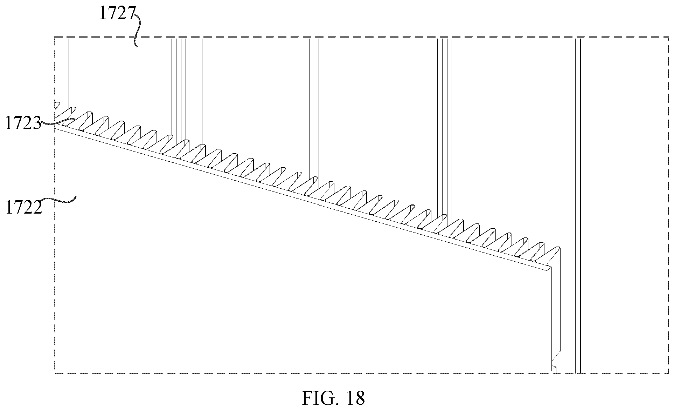

Referring to FIG. 12 to FIG. 18, in some embodiments, the air conditioner comprises the refrigerant flow path 400 and the electronic control box 100. The electronic control box 100 comprises the box assembly 110, the circuit board assembly 140, the fan 130, a heat exchanger assembly 170, and the evaporator 150. The box assembly 110 comprises a box body 111, and an air duct is formed in the box body 111. As shown in FIG. 1, the fan 130, the circuit board assembly 140, the heat exchanger assembly 170, and the evaporator 150 are all located in the air duct, and the fan 130 is constructed to form an airflow in the air duct. Therefore, when the airflow formed by the fan 130 flows through the circuit board assembly 140 in the air duct, the heat of the circuit board assembly 140 is taken away, and heat is dissipated from the circuit board assembly 140.

It should be noted that, to facilitate the airflow flowing through the circuit board assembly 140, the temperature of the airflow flowing out of the fan 130 is lower than the temperature of the circuit board assembly 140. To enhance the heat dissipation efficiency of the fan 130 to the circuit board assembly 140, the airflow flowing out of the fan 130 may be cold air to absorb more heat from the circuit board assembly 140 and achieve a better heat dissipation effect on the circuit board assembly 140.

The electronic control box comprises the heat exchanger assembly 170 and the evaporator 150, and the heat exchanger assembly 170 and the evaporator 150 are located in the air duct. The heat exchanger assembly 170 contacts with the circuit board assembly 140 (as shown in FIG. 1), and dissipates heat from the circuit board assembly 140 by heat conduction. Therefore, the evaporator 150 refrigerates the airflow passing through the evaporator 150 by means of the phase change of the refrigerant. The heat exchanger assembly and the evaporator 150 operate together to provide good heat dissipation to the circuit board assembly 140.

Specifically, the heat exchanger assembly 170 comprises a heat exchanger and a heat conductor connected to each other. The heat conductor is located between the circuit board assembly 140 and the heat exchanger and is configured to conduct heat from the circuit board assembly 140 to the heat exchanger. The evaporator 150 is configured to refrigerate the airflow passing through the evaporator 150 by means of the phase change of the refrigerant. The heat exchanger is configured to refrigerate the circuit board assembly 140 through heat conduction and heat exchange between a low-temperature refrigerant and the circuit board assembly 140.

To enable the evaporator 150 and the heat exchanger 172 to operate normally by the refrigerant, the air conditioner further comprises the refrigerant flow path 400, an indoor unit 300, and an outdoor unit 200. The indoor unit 300 is connected to the outdoor unit 200, and the electronic control box 100 is disposed in the outdoor unit 200 to realize a control of the outdoor unit 200 and the indoor unit 300 by the electronic control box 100.

The indoor unit 300 is in communication with the outdoor unit 200 through the refrigerant flow path 400. The refrigerant flow path 400 internally has a compressor 800, an outdoor heat exchanger 210, an electronic expansion valve 700, an indoor heat exchanger (not shown in the figures), and other components that are connected. The electronic control box 100 may comprise the evaporator 150 and the heat exchanger (not shown in the figures). The evaporator 150 may be connected between the electronic expansion valve 700 and the compressor 800 via a branch line. The heat exchanger is also disposed in the refrigerant flow path 400.

In an optional embodiment, the heat exchanger is a microchannel heat exchanger. The microchannel heat exchanger consists of a main path and an auxiliary path. An inlet of the main path is connected to an outlet of the heat exchanger of the outdoor unit. An outlet of the main path is divided into two. One path is connected to an inlet of the auxiliary path, and another path enters the indoor unit. An outlet of the auxiliary path is connected to a gas-liquid separator. Heat exchange is performed between that main path and the auxiliary path, and the auxiliary path refrigerates the main path. A refrigerant of the main path is overcooled, which can realize a function of an economizer. The overcooled refrigerant of the main path flows to the indoor unit for heat exchange, and the heat exchange efficiency of the indoor unit is improved.

In other embodiments, the heat exchanger is not limited to the microchannel heat exchanger, and may also be a radiator in a form of other refrigerant pipes.

The heat exchanger assembly comprises the heat exchanger and the heat conductor connected to each other. The heat conductor is located between the circuit board assembly and the heat exchanger 172 and conducts the heat from the circuit board assembly 140 to the heat exchanger. For example, the heat conductor may comprise, but is not limited to, a metal sheet, or a metal block that is thermally conductive. In this way, on a basis of heat dissipation from the circuit board assembly 140 by the fan 130, the heat of the circuit board assembly 140 can be absorbed by the heat conductor, and absorbed heat can be conducted to the heat exchanger.

Meanwhile, the evaporator 150 is connected to the refrigerant flow path 400, and configured to refrigerate the airflow passing through the evaporator 150 by means of the phase change of the refrigerant flowing through the evaporator 150. Therefore, double heat dissipation of the circuit board assembly through the heat exchanger and the evaporator 150 is facilitated, ensuring that the circuit board assembly has a good heat dissipation effect.

Since the evaporator 150 is connected to the refrigerant flow path 400 of the air conditioner, the refrigerant in the refrigerant flow path 400 is usually the low-temperature refrigerant. When the low-temperature refrigerant flows through the heat exchanger 172 through the refrigerant flow path 400, the low-temperature refrigerant will conduct heat and dissipate heat with the heat conductor 171, thereby refrigerating the heat conductor 171 to ensure a continuous heat dissipation effect of the heat conductor 171 on the circuit board assembly 140.

At the same time, since the evaporator 150 is located in the air duct, the airflow (such as cold air) flowing out of the fan 130 absorbs heat from the circuit board assembly 140 and becomes hot air. When flowing through the evaporator 150 along the air duct, the low-temperature refrigerant flowing through the evaporator 150 exchanges heat with airflow passing through the evaporator 150 at a higher temperature, such as hot air, to absorb heat from the hot air. Therefore, the low-temperature refrigerant absorbs heat and changes phase to form gas, and the hot air is changed into cold air to refrigerate the airflow flowing through the evaporator 150. In this way, the airflow that has been cooled can be ensured to continue to absorb heat from the circuit board assembly 140 when flowing through the circuit board assembly 140 along the air duct, thereby further achieving the heat dissipation effect of the circuit board assembly 140.

In this way, in the present disclosure, by disposing the evaporator 150, the airflow flowing through the circuit board assembly 140 is refrigerated by means of the phase change of the refrigerant flowing through the evaporator 150. The airflow refrigerated by the refrigerant performs air-cooling heat dissipation on the circuit board assembly 140, and thus cooperates with the heat exchanger assembly to ensure the normal operation of the electronic component, the circuit board assembly 140, and the electronic control box 100.

The inlet of the evaporator 150 is constructed to be in communication with the low-pressure liquid refrigerant flow path 410 in the refrigerant flow path 400. The outlet of the evaporator 150 is constructed to be in communication with the low-pressure gaseous refrigerant flow path 420 in the refrigerant flow path 400, thereby enabling the evaporator 150 to be in communication with the refrigerant flow path 400. In this way, a refrigerant in the low-pressure liquid refrigerant flow path 410 can flow to the evaporator 150 via the inlet of the evaporator 150. After the refrigerant cools the airflow flowing through the evaporator 150, the refrigerant can flow through the low-pressure gaseous refrigerant flow path 420 via the outlet of the evaporator 150.

The inlet of the evaporator 150 is connected to the low-pressure liquid refrigerant flow path 410 in the refrigerant flow path 400, and the outlet of the evaporator 150 is connected to the low-pressure gaseous refrigerant flow path 420 in the refrigerant flow path 400. Therefore, the refrigerant in the refrigerant flow path 400 can enter an interior of the evaporator 150 through the inlet of the evaporator 150. In response to flowing through the evaporator 150 and exchanging heat with the airflow passing through evaporator 150 to be endothermic gasification, the refrigerant in the refrigerant flow path 400 enters the low-pressure gaseous refrigerant flow path 420 from the outlet of evaporator 150. In this way, when the refrigerant flow path 400 is a closed loop, a circulation flow of the refrigerant in the refrigerant flow path 400 can be realized, thereby contributing to a continuous cooling effect of the airflow flowing through the evaporator 150.

The box body 111 is a sealed box body, and the air duct is the circulation air duct. Since the heat exchanger 172 can refrigerate the heat conductor 171 and the airflow passing through the heat conductor 171, continuous heat dissipation of the circuit board assembly 140 can be achieved without convection between the fan 130 and air outside the electronic control box 100. Therefore, when the box body 111 is the sealed box body and the air duct is the circulation air duct, the fan 130 and the heat exchanger 172 are not affected to continuously dissipate heat from the circuit board assembly 140, and a convection vent on an outer surface of the box body 111 can be effectively avoided, thereby ensuring a sealing performance of the electronic control box 100 to avoid an influence of air outside the electronic control box 100 on the heat dissipation effect of the fan 130 on the circuit board assembly 140. In addition, foreign matters such as insects, dust, or other impurities can be prevented from entering the electronic control box 100 and damaging the circuit board assembly 140.

The box assembly 110 may further comprise the separator 120. The separator 120 divides an interior of the box body 111 into the first cavity 101a and the second cavity 101b. The box assembly 110 has at least two vents. The first cavity 101a and the second cavity 101b are connected through the vents, and constitute the circulation air duct together with the vents. In this way, when airflow generated by the fan 130 flows in the circulation air duct and is refrigerated by the evaporator 150, the airflow generated by the fan 130 can realize the continuous heat dissipation of the circuit board assembly 140, and at the same time, ensure the sealing performance of the box body 111, to prevent the air outside the electronic control box 100 from affecting the heat dissipation effect of the fan 130 on the circuit board assembly 140.

The box body 111 internally has the accommodation cavity 101. The separator 120 is disposed in the box body 111 and separates the accommodation cavity 101 into the first cavity 101a and the second cavity 101b which are independent of each other. The vent is disposed at the separator 120, and is in communication with the first cavity 101a and the second cavity 101b. The vent may comprise the first vent 102a and the second vent 102b. The first vent 102a may be disposed at a first end 1201 of the separator 120, and the second vent 102b may be disposed at a second end 1202 of the separator 120. Therefore, the first cavity 101a and the second cavity 101b are connected through the first vent 102a and the second vent 102b, and the circulation air duct is formed in the box assembly 110 and dissipates the heat of the circuit board assembly 140.

In some embodiments, the separator 120 may be vertically disposed in the accommodation cavity 101, allowing the first cavity 101a and the second cavity 101b to be two vertical cavities disposed side by side in the box body 111. In this case, the first vent 102a may also be referred to as an upper vent, and the second vent 102b may also be referred to as a lower vent, to facilitate the airflow in the fan 130 to flow in the circulation air duct.

Alternatively, in other embodiments, the separator 120 may be horizontally disposed in the accommodation cavity 101. In this case, the separator 120 may divide the accommodation cavity 101 into two horizontal accommodation cavities 101 arranged in the vertical direction, i.e., the first cavity 101a and the second cavity 101b. The vertical direction may be understood as a Y direction in FIG. 3.

It should be noted that the separator 120 may be sealingly connected to an inner wall of the box body 111 by engaging, interference fit, or other means. For example, the separator 120 may comprise, but is not limited to, a partition board, and a structural size of the partition board is adapted to a structural size of the box body 111. Therefore, the accommodation cavity 101 may be divided into the first cavity 101a and the second cavity 101b which are independent of each other by the partition board. In the present disclosure, an arrangement direction, a connection mode, and a structure of the separator 120 in the accommodation cavity 101 are not further limited.

A structure of the air conditioner of the present disclosure will be further described by taking the example that the separator 120 is vertically disposed in the accommodation cavity 101.

Since the heat exchanger assembly mainly performs heat dissipation and cooling for the circuit board assembly 140 through heat conduction, the heat exchanger assembly may be disposed at a side of the circuit board assembly 140 at which the electrical element 142 is disposed, or disposed at a side of the circuit board assembly 140 away from the electrical element 142, and connected to the circuit board assembly 140 through a heat conduction structure. The evaporator 150 may be disposed at a bottom, top, or side of the electronic control box 100.

For example, the circuit board assembly 140 is disposed in the first cavity 101a, and the heat exchanger 172 is disposed in the second cavity 101b. The circuit board assembly 140 and the heat exchanger 150 may be fixed to the separator 120 in a manner of engaging, fasteners, such as screws or bolts. In this way, the circuit board assembly 140 and the heat exchanger 172 are disposed in different accommodation cavities 101. Therefore, the circuit board assembly 140 and the heat exchanger 172 are disposed in the circulation air duct, and a formation of the circulation air duct can be facilitated.

The fan 130 is located in at least one of the first cavity 101a and the second cavity 101b. That is, the fan 130 may be located in the first cavity 101a. Alternatively, in some embodiments, the fan 130 may also be embedded and blocked in the first vent 102a or the second vent 102b of the separator 120. Therefore, the fan 130 is located in the first cavity 101a and the second cavity 101b at the same time. Alternatively, in other embodiments, the fan 130 may also be located in the second cavity 101b. In this way, the airflow in the fan 130 flows in the circulation air duct to dissipate the heat of the circuit board assembly 140, and the fan 130 can be arranged in a more diversified manner in the electronic control box 100. In this embodiment, an arrangement position of the fan 130 in the electronic control box 100 is not further limited.

The fan 130 has an air outlet side 1302 and an air inlet side 1301. The airflow in the fan 130 can flow out from the air outlet side 1302, and then flow back to the air inlet side 1301 through the circulation air duct, so as to flow out from the air outlet side 1302 again to dissipate the heat of the circuit board assembly 140. The fan 130 may be disposed at the first vent 102a, the second vent 102b, or a middle of the separator 120. In this embodiment, a position of the fan 130 in the box assembly 110 is not further limited.

In some embodiments, airflow at the outlet side 1302 may flow through the circuit board assembly 140, the evaporator 150, and the inlet side 1301 in sequence in the circulation air duct. Alternatively, in other embodiments, the airflow at the air outlet side 1302 may further flow through the evaporator 150, the circuit board assembly 140, and the air inlet side 1301 in the circulation air duct. Therefore, the airflow in the fan 130 may form an airflow loop in the circulation air duct for dissipating heat of the circuit board assembly 140, and at the same time, the flowing direction of the airflow in the electronic control box 100 may be more diversified.

In the following, taking that the fan 130 is located at the first vent 102a of the first cavity 101a, and the airflow at the air outlet side 1302 flows through the circuit board assembly 140, the evaporator 150, and the air inlet side 1301 in sequence in the circulation air duct as an example, the structure of the air conditioner of the present disclosure is further be defined.

A specific structure of the heat exchanger assembly is further described as follows.

In the heat exchanger assembly 170, the heat conductor 171 may be connected to the heat exchanger 172 and attached to the circuit board assembly 140, so that the heat conductor 171 may absorb the heat of the circuit board assembly 140, thereby achieving rapid heat dissipation and cooling of the circuit board assembly 140. Furthermore, since the heat conductor 171 is connected to the heat exchanger 172, the heat conductor 171 and a refrigerant circulating in the heat exchanger 172 can be easily heat conducted to dissipate heat, so as to refrigerate the heat conductor 171. Therefore, the heat conductor 171 can continuously dissipate heat from the circuit board assembly 140, and the heat dissipation effect of the circuit board assembly 140 and the electronic control box 100 can be enhanced.

The heat conductor 171 may be attached to a side of the separator 120 opposite to the circuit board assembly 140. Therefore, the heat on the circuit board assembly 140 may be conducted to the heat conductor 171 through the separator 120.

Alternatively, in some embodiments, the heat conductor 171 may be embedded in the separator 120 and exposed on a surface of the separator 120. In this case, the heat conductor 171 may be directly attached to the circuit board assembly 140. In the present disclosure, a relative position of the heat conductor 171 to the separator 120 is not further limited.

The structure of the air conditioner of the present disclosure will be further described below by taking an example that the heat conductor 171 is attached to the separator 120.

It should be noted that, the heat exchanger assembly 170 may be directly fixed in the second cavity 101b by engaging, fasteners, brackets, or other means to ensure that the heat conductor 171 can be attached to the circuit board assembly 140.

Specifically, the circuit board assembly 140 may comprise the circuit board 141 and the electrical element 142. The electrical element 142 is disposed at a same surface of the circuit board 141. The heat exchanger 172 may be disposed at a surface of the circuit board 141 opposite to the electrical element 142, and disposed opposite to the electrical element 142. The heat conductor 171 and the like are in contact with the circuit board 141 and are in a heat conduction connection, so as to absorb heat on the electrical element 142 and achieve an objective of dissipating heat and refrigerating the electrical element 142.

The evaporator 150 may be disposed at the bottom, top, or side of the electronic control box, and is configured to refrigerate air and lower a temperature in the electronic control box, so as to generate the cooling airflow under an action of the fan. The cooling airflow dissipates heat from the electrical element 142.

The electrical element 142 may be disposed at a surface of the circuit board 141 facing the first cavity 101a (i.e., a front surface of the circuit board 141), and the evaporator 150 may be disposed at a back surface of the circuit board 141. Structures of the heat conductor 171 and the heat exchanger 172 are not shown in the figures.

The heat conductor 171 may be of a shape of a flat plate. The heat conductor 171 has opposite sides attached to the circuit board 141 and the heat exchanger 172, respectively. In this way, a contact area between the heat conductor 171 and the circuit board 14 can be increased, thereby improving a heat conduction rate of heat generated by the electrical element 142 to the heat exchanger 172 and improving the heat dissipation effect of the heat conductor 171 on the circuit board assembly 140.

To facilitate conducting the heat from the electrical element 142 to the heat conductor 171 through the circuit board assembly 141, the separator 120 may be made of a heat-conductive material such as a heat-conductive metal, which may be copper or the like, at a connection of the circuit board assembly 140 with the heat conductor 171. A heat-conductive adhesive may be disposed between the heat conductor 171 and the circuit board assembly 140. Specifically, the heat-conductive adhesive may be disposed between the heat conductor 171 and the separator 120, or between the heat conductor 171 and the circuit board assembly 140. In this way, while heat conduction on the circuit board assembly 140 is accelerated by the heat-conductive metal or the heat-conductive adhesive, an arrangement of the heat-conductive adhesive can also help to realize a fixation of the circuit board assembly 140 and the heat conductor 171 on the separator 120.

Alternatively, in some embodiments, the heat-conductive adhesive may be combined with the heat-conductive metal on the separator 120 to further accelerate the heat conduction on the circuit board assembly 140. In this embodiment, a manner of heat conduction between the heat conductor 171 and the circuit board assembly 140 is not further limited.

According to whether the electrical element 142 generates heat, the electrical element 142 on the circuit board 141 may comprise a heat generation device and a non-heat generation device. The heat generation device may comprise, but is not limited to, an intelligent power module (IPM) in the circuit board assembly 140. The heat conductor 171 may be attached to the separator 120 and disposed opposite to the heat generation device to dissipate heat from the circuit board assembly 140. To accelerate heat dissipation from the circuit board assembly 140, the heat conductor 171 may be attached to the separator 120 at a position opposite to the high-temperature electrical element 142, such as an IPM.

When the fan 130 is disposed in the first cavity 101a, the air outlet side 1302 of the fan 130 may be disposed opposite to the heat generation device. Therefore, the airflow at the air outlet side 1302 may be directly blown to the heat generation device, thereby enhancing the heat dissipation effect of the fan 130 on the electrical element 142.

In other embodiments, the heat exchanger 172 is the microchannel heat exchanger. The microchannel heat exchanger consists of the main path and the auxiliary path. The inlet of the main path is connected to the outlet of the heat exchanger of the outdoor unit. The outlet of the main path is divided into two. One path is connected to the inlet of the auxiliary path, and another path enters the indoor unit. The outlet of the auxiliary path is connected to the gas-liquid separator. Heat exchange is performed between that main path and the auxiliary path, and the auxiliary path refrigerates the main path to allow the refrigerant of the main path to be overcooled, which can realize the function of an economizer. The overcooled refrigerant of the main path flows into the indoor unit for heat exchange, and the heat exchange efficiency of the indoor unit is improved.

Alternatively, the microchannel heat exchanger can be an economizer of the air conditioner. Therefore, the heat exchanger in the heat exchanger assembly 170 has the same function as an existing structure in the air conditioner at the same time, which can lower the structural complexity of the air conditioner and save costs.

In an optional embodiment, the heat exchanger 172 has a plurality of microchannels 1727 configured to be in communication with the refrigerant flow path 400 and configured to perform heat conduction and dissipate heat from the heat conductor 171 via a refrigerant flowing through the microchannels 1727.

The heat conductor 171 may be attached to a side of the microchannel 1727 facing the circuit board assembly 140. Therefore, the heat conductor 171 is attached to the circuit board assembly 140 to absorb the heat from the circuit board assembly 140, thereby performing heat conduction and dissipating heat from the circuit board assembly 14.

The plurality of microchannels 1727 may be arranged in parallel to form a microchannel tube group. The heat exchanger 172 further comprises connection pipes 1726 distributed at opposite ends of the microchannel tube group. Each microchannel 1727 is in communication with the refrigerant flow path 400 through the connection pipes 1726 at the opposite ends of the microchannel tube group. The heat conductor 171 may be attached to a side of the microchannel tube assembly facing the circuit board assembly 140. In this way, when the refrigerant flows through the microchannels 1727, heat conduction and heat dissipation can be performed on the heat conductor 171 by the refrigerant.

The heat exchange fin 1721 and heat conductor 171 may be attached to one side of the plurality of microchannels 1727. Therefore, the refrigerant flowing through the microchannel 1727 can perform heat conduction and dissipate heat to the heat exchange fin 1721, enhancing a cooling effect of the heat exchange fin 1721 on the airflow and ensuring the heat dissipation effect of the fan 130 on the circuit board assembly 140. In addition, a mounting space occupied by means of the heat exchanger assembly 170 in the electronic control box 100 can be reduced, contributing to a miniaturization of the electronic control box 100.

At the same time, when the airflow passes through the heat exchange fin 1721, the airflow performs heat exchange with the heat exchange fin 1721, while the microchannel 1727 can refrigerate the airflow again by means of phase change of the refrigerant flowing through the microchannel 1727 to improve the heat dissipation effect, thereby ensuring the normal operation of the electronic component, the circuit board assembly 140, and the electronic control box 100.

The heat exchange fin 1721 may comprise a fixing plate 1722 and a plurality of fins 1723. The fixing plate 1722 and the plurality of microchannels 1727 are located at opposite sides of the fin 1723. In this way, an end of the microchannel 1727 of the fin 1723 can be sealed by the fixing plate 1722. Therefore, airflow flowing through the heat exchange fin 1721 can pass through a space between two adjacent fins 1723 as much as possible, and a cooling effect of the heat exchange fin 1721 on the airflow can be ensured.

It should be noted that other heat exchange assemblies 140 can be used to refrigerate the heat conductor 171 in the present disclosure. In this embodiment, a structure of the heat exchange assembly 140 is not further limited.

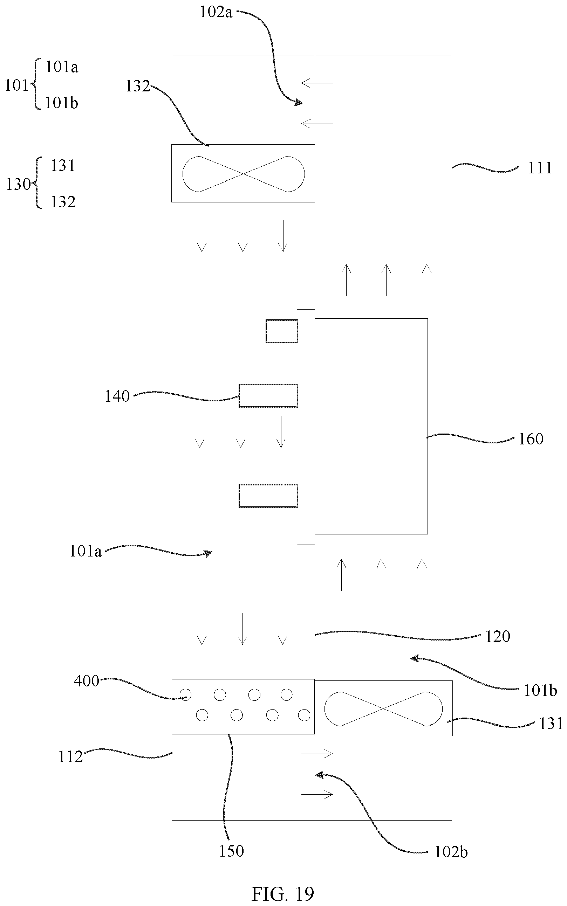

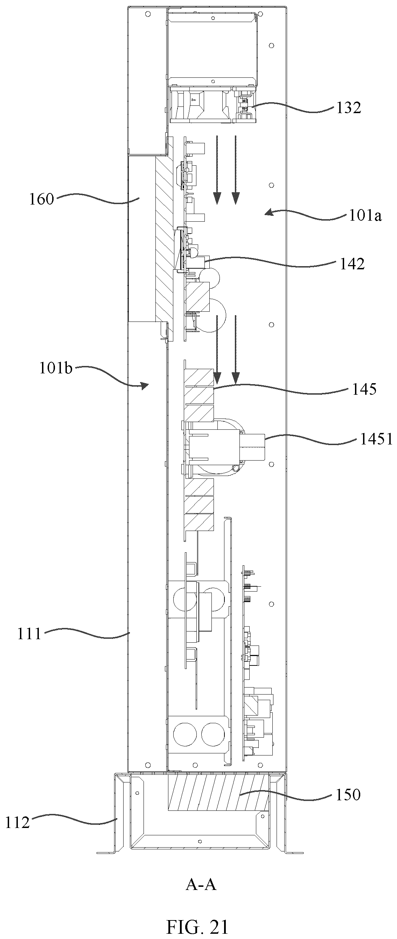

Referring to FIG. 19 to FIG. 24, in some embodiments, the air conditioner comprises the electronic control box 100 and the refrigerant flow path 400. The electronic control box 100 comprises the box body 111, the evaporator 150, the circuit board assembly 140, and the fan 130. The box body 111 has the accommodation cavity 101. The circulation air duct is formed in the accommodation cavity 101. The circuit board assembly 140 and the fan 130 are arranged in the circulation air duct. The box body 111 can protect the circuit board assembly 140 and the fan 130 in the accommodation cavity 101, to prevent rainwater, mosquitoes, and dust outside the electronic control box 100 from entering the accommodation cavity 101, thereby ensuring reliability of a function of each component in the accommodation cavity 101.

The fan 130 comprises the first fan 131 configured to drive air to flow in the circulation air duct. The evaporator 150 is connected to the refrigerant flow path 400 and configured to refrigerate the circuit board assembly 140 by means of the phase change of the refrigerant.

It should be understood that, to improve a rationality of a spatial layout in the accommodation cavity 101, the plurality of electrical elements may be arranged in the flowing direction of the cooling airflow. When the first fan 131 is started and operates, the cooling airflow may be formed in the accommodation cavity 101, and the cooling airflow may flow through the plurality of electrical elements in turn in the accommodation cavity 101. Moreover, since an air outlet of the first fan 131 is opposite to the electrical element, the cooling airflow blown out by the first fan 131 can blow against the electrical element and take away heat. When the cooling airflow flows through the evaporator 150, the evaporator 150 during operating can refrigerate the cooling airflow and absorb the heat of the cooling airflow flowing through the evaporator 150 to lower the temperature of the cooling airflow. Therefore, when the cooling airflow is circulated back to the first fan 131 and blown out again, the temperature of the cooling airflow can be lower than the surface temperature of the circuit board assembly 140 when the circuit board assembly 140 is in operation. Therefore, when the cooling airflow flows through the circuit board assembly 140, the cooling airflow can continuously and cyclically exchange heat with each electrical element of the circuit board assembly 140, thereby reducing the temperature of the electrical element generating heat on the circuit board assembly 140 and achieving a good heat dissipation effect.

In addition, when the electronic control box 100 is applied to the air conditioner, the circuit board assembly 140 is configured to control the operation of the air conditioner, for example, control the operation of the compressor, the fan, and the like in the air conditioner. In addition, the circuit board assembly 140 can control the operation of each first fan 131 in the electronic control box 100.

It should be noted that the electronic control box 100 in the embodiment of the present disclosure arranges a relative position between the first fan 131 and the electrical element, and cooperates with the evaporator 150. On the one hand, the first fan 131 is used to blow directly against the electrical element to ensure that all or most of the formed cooling airflow can pass through the electrical element. Therefore, the contact area between the cooling airflow and the electrical element can be increased, and the heat dissipation effect can be further improved. On the other hand, the electronic control box 100 is not influenced by the external environment can be ensured, and under any operating condition, when the electronic control box 100 operates and needs to dissipate heat, the temperature of the cooling airflow can be lower than the surface temperature of the circuit board assembly 140. The low temperature of the evaporator 150 can only affect the air and airflow in the accommodation cavity 101, and condensation generated by the circuit board assembly 140 due to overcooling can be avoided by utilizing the airflow that has been cooled to dissipate heat, thereby ensuring the circuit board assembly 140 to operate well.

First, the flowing direction and flow path of the cooling airflow, and a structural layout inside the accommodation cavity 101, will be described in detail below.

Referring to FIG. 19 to FIG. 21, those skilled in the art can understand that the circuit board assembly 140 may comprise the circuit board (not shown in the figures) and the plurality of electrical elements. The plurality of electrical elements is electrically connected to the circuit board to form a circuit structure. The cooling airflow flows in a direction parallel to a board surface of the circuit board. When the circuit board assembly 140 is in operation, the electrical element generates heat. When the cooling airflow flows through the circuit board assembly 140, heat can be removed by the electrical element.

In a possible implementation, the electronic control box 100 may further comprise the separator 120 disposed in the accommodation cavity 101. The separator 120 may be connected to the inner wall of the accommodation cavity 101, and the separator 120 and the inner wall of the accommodation cavity 101 together define the circulation air duct for the flowing of the cooling airflow. The circuit board assembly 140 and the first fan 131 are located at different positions of the circulation air duct.

It should be understood that the circulation air duct defined by the separator 120 in the accommodation cavity 101 can not only provide space and layout positions for mounting the plurality of electrical elements of the circuit board assembly 140 and the first fan 131, but also provide a guide for the flow of the cooling airflow. Therefore, the circulation flow of the cooling airflow in the accommodation cavity 101 can be realized to allow the temperature of the cooling airflow to be maintained within a reasonable range and ensure a good heat dissipation effect.

In some embodiments, the separator 120 may divide the accommodation cavity 101 into a plurality of cavities that are connected to each other. Some of the plurality of cavities constitute a part of the circulation air duct, and the plurality of cavities is sequentially connected end-to-end to form a complete circulation air duct. The first fan 131 and the circuit board assembly 140 may be disposed in one cavity. Therefore, the first fan 131 can directly blow the electrical element.

For example, the separator 120 may be connected to the box body 111 by fasteners, such as screws, bolts, snaps, etc. Alternatively, the separator 120 may be connected to the box body 111 through welding. Alternatively, the separator 120 may be inserted into the accommodation cavity 101, and limited by forming the guide groove on the inner wall of the accommodation cavity 101. The embodiments of the present disclosure do not limit the specific connection mode between the separator 120 and the box body 111.

It should be understood that the separator 120 can divide the accommodation cavity 101 into the first cavity 101a and the second cavity 101b. The first cavity 101a and the second cavity 101b are connected end-to-end to allow the air duct to form a circulating air path. The first fan 131 can be disposed in the first cavity 101a, and the electrical element is disposed at the side of the separator 120 facing the first cavity 101a. The second cavity 101b can form a return air path of the cooling airflow.

For example, the circuit board assembly 140 may be located at the air outlet of the first fan 131. In the cooling airflow flowing direction, a projection of the first fan 131 at least partially overlaps a projection of the circuit board assembly 140. Therefore, the airflow blown out by the first fan 131 may directly face the circuit board assembly 140, thereby ensuring that the cooling airflow has a large contact area with the circuit board assembly 140, and improving the heat dissipation effect.

In some embodiments, a top end of the separator 120 and the inner wall of the accommodation cavity 101 together define the first vent 102a. A top end of the first cavity 101a and a top end of the second cavity 101b are connected through the first vent 102a. The second vent 102b can be formed by a bottom end of the separator 120 and the inner wall of the accommodation cavity 101. A bottom end of the first cavity 101a and a bottom end of the second cavity 101b are connected through the second vent 102b. The first fan 131 is located at a top of the first cavity 101a, and an air inlet of the first fan 131 is in communication with the first vent 102a. Therefore, the cooling airflow blown by the first fan 131 can pass through the first cavity 101a from top to bottom, and return from the top of the first cavity 101a after passing through the second cavity 101b, thereby improving the smoothness of air circulation.

It should be understood that the evaporator 150 may be located at the bottom of the first cavity 101a. The circuit board assembly 140 may comprise the circuit board and the plurality of electrical elements disposed at the circuit board. The plurality of electrical elements may be sequentially arranged between the first fan 131 and the evaporator 150. After the cooling airflow passes through the electrical element and absorbs heat, the heat absorbed by the cooling airflow may be carried away by the evaporator 150, thereby reducing the temperature of the evaporator 150.

For example, in the flowing direction of the cooling airflow, projections of at least some of the plurality of electrical elements have an overlap region with a projection of the first fan 131. Therefore, after the cooling airflow is blown out of the first fan 131, the flowing direction of the airflow is aligned with at least a part of the electrical element, thereby increasing a contact surface of the cooling airflow with the electrical element.

In a possible implementation, at least two first fans 131 are provided, and the at least two first fans 131 are arranged side by side in the circulation air duct to be arranged opposite to different electrical elements, respectively. Therefore, a coverage area of the cooling airflow can be increased, and each electrical element can be ensured to obtain a good heat dissipation effect.

To improve the heat dissipation efficiency, the radiator 160 may be disposed in the electronic control box 100, and the radiator 160 may also be located in the accommodation cavity 101. The radiator 160 may be understood as the extension of the heat dissipation surface of the circuit board assembly 140 or the heat dissipation structure of the circuit board assembly 140. The heat of the circuit board assembly 140 may be transferred to the radiator 160. When the cooling airflow flows through the radiator 160, the heat may be efficiently removed, achieving a better heat dissipation effect.

For example, the radiator 160 may be relatively independent of the circuit board assembly 140. During assembling, the radiator 160 may be mounted at the side of the circuit board 141 away from the electrical element 142, or the radiator 160 may be the derivative structure of the circuit board 141 to be fixedly connected to the circuit board 141 or integrally formed with the circuit board 141, which is not specifically limited in the embodiments of the present disclosure.

In a possible implementation, the radiator 160 and the circuit board assembly 140 may be located at different sides of the separator 120. The radiator 160 is constructed to dissipate heat from the circuit board assembly 140 through heat conduction. Therefore, the heat of the circuit board assembly 140 can be conducted by utilizing the radiator 160, and the area of effective air-cooling heat dissipation for the circuit board assembly 140 can be increased, thereby improving the heat dissipation efficiency.

It should be understood that the radiator 160 may be located in the second cavity 101b. For example, an opening may be formed at the separator 120 to allow the circuit board assembly 140 and the radiator 160 to contact through the opening, thereby realizing heat conduction from the circuit board assembly 140 to the radiator 160.

It should be noted that, when the accommodation cavity 101 is the sealed accommodation cavity 101, an interior of the electronic control box 100 is a sealed space. When the cooling airflow in the accommodation cavity 101 flows, the cooling airflow does not convect with the air outside the electronic control box 100. Therefore, external water vapor is difficult to enter the electronic control box 100, and the water vapor content in the accommodation cavity 101 of the electronic control box 100 is limited. When the evaporator 150 absorbs heat and refrigerates the cooling airflow 500, the evaporator 150 also has the dehumidifying effect on the air. Therefore, condensation is difficult to be generated in the electronic control box 100.

In one possible implementation, the fan 130 may comprise the first fan 131 and a second fan 132. The electrical element may comprise a reactor 143 opposite to the air outlet of the first fan 131, and a frequency converter module 144 opposite to an air outlet of the second fan 132. Therefore, cooling airflow of the first fan 131 may blow directly against the reactor 143, and cooling airflow of the second fan 132 can directly blow the frequency converter module 144. Therefore, the reactor 143 and the frequency converter module 144 have a good heat dissipation effect.

When the electronic control box 100 is applied to the air conditioner, the frequency converter module 144 can be configured to control the compressor and the fan. The reactor 143 is electrically connected to the frequency converter module 144, and the reactor 143 is configured to eliminate harmonics and improve a shock resistance of a circuit, ensuring the circuit operates smoothly.

It should be understood that the frequency converter module 144 at least partially extends to the air outlet of the first fan 131. A capacitor 1441 is disposed at the frequency converter module 144, and the capacitor 1441 is opposite to the air outlet of the first fan 131. Since the capacitor 1441 generates a large amount of heat, the capacitor 1441 on the frequency converter module 144 can be dissipated by the cooling airflow of the first fan 131, which can maintain an operating temperature of the capacitor within a reasonable range.

For example, the plurality of capacitors 1441 may be arranged in an array, and a space is formed between adjacent capacitors 1441 to ensure the heat dissipation effect.

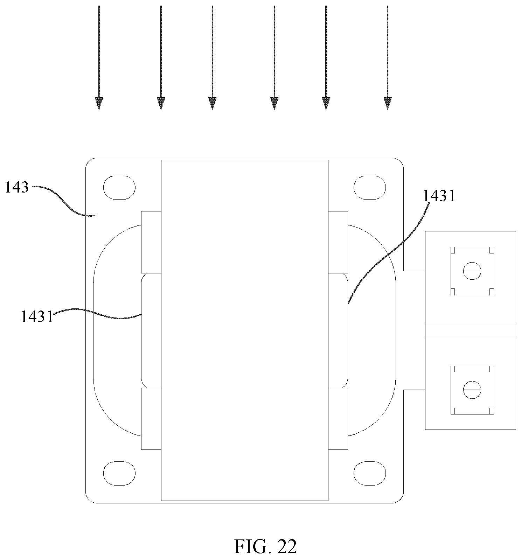

FIG. 22 is a schematic view of heat dissipation of the reactor by the cooling airflow in the electronic control box in the air conditioner according to an embodiment of the present disclosure.

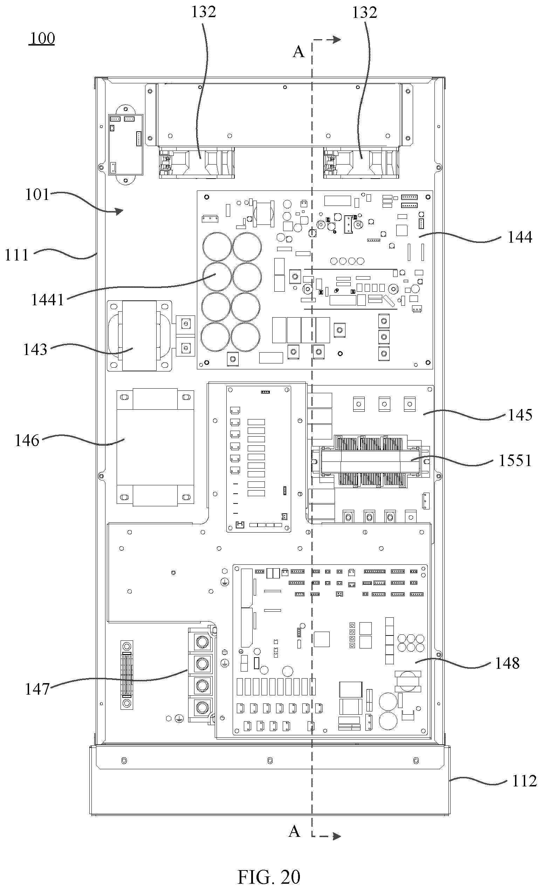

Referring to FIG. 22 and in conjunction with FIG. 19 and FIG. 20, the reactor 143 may comprise a first coil winding 1431. A connecting line between two ends of the first coil winding 1431 is perpendicular to the flowing direction of the cooling airflow formed by the first fan 131, which ensures that two sides of the first coil winding 1431 can be effectively released from the cooling airflow, thereby maintaining a balance of heat dissipation of the reactor 143 as a whole.

In a possible implementation, the electrical element may comprise a filter module 145, and the filter module 145 may be located at a side of the frequency converter module 144 facing away from the second fan 132. After the cooling airflow of the second fan 132 flows through the frequency converter module 144, heat dissipation may be performed on the filter module 145. By improving a space utilization rate in the accommodation cavity 101 and maintaining the rationality of the layout, an operating temperature of the filter module 145 can be maintained within a reasonable range.

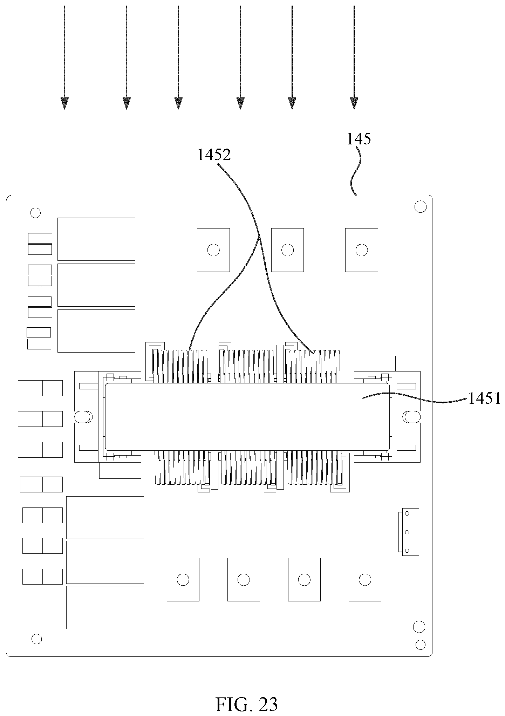

FIG. 23 is a schematic view of heat dissipation of the filter module by cooling airflow in the electronic control box of the air conditioner according to an embodiment of the present disclosure. Referring to FIG. 5 and in conjunction with FIG. 1 and FIG. 2, the filter module 145 may be provided with a filter inductor 1451 with a second coil winding 1452. A width direction of the second coil winding 1452 is parallel to a flowing direction of the cooling airflow formed by the second fan 132. Therefore, a contact area between the filter inductor 1451 and the cooling airflow can be enlarged, and the heat dissipation effect of the filter inductor 1451 can be improved.

In addition, the electrical element may further comprise a transformer 146, and the transformer 146 may enable the electronic control box 100 to be applied to different voltage occasions and satisfy different standard voltage standards, for example, 220 V, 110 V, 380 V, etc. The transformer 146 may be located at a side of the reactor 143 facing away from the first fan 131. Therefore, the transformer 146 may be arranged by utilizing the space at the side of the filter inductor 1451 to improve the space utilization rate. At the same time, the cooling airflow in the first fan 131 can flow through the transformer 146 to maintain the operating temperature of the transformer 146 within a reasonable range.

In some embodiments, both the first fan 131 and the second fan 132 may be located at a top of the accommodation cavity 101, and the air outlets of both the first fan 131 and the second fan 132 face downward to allow the cooling airflow to flow from top to bottom. Therefore, the smoothness of the cooling airflow formed by the first fan 131 and the second fan 132 can be maintained, and mutual influence or turbulence can be avoided.

In addition, it should be noted that the electrical element may further comprise a main control board 148 and a terminal block 147 that are both located at a side of the filter module 145 away from the first fan 131. The terminal block 147 connects an external power source into the electronic control box 100, and the main control board 148 is configured to control an operation of the electrical element such as the first fan 131 and the frequency converter module 144.

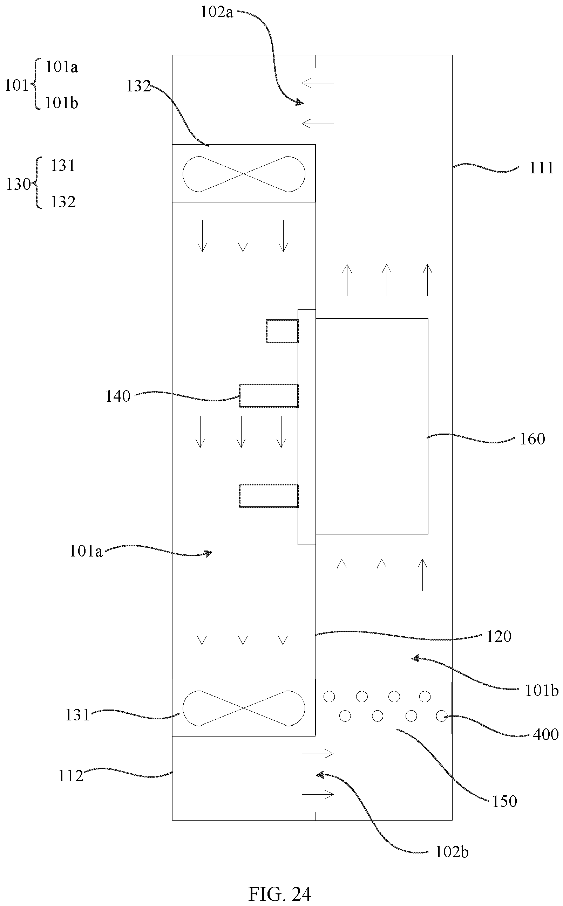

Referring to FIG. 24 and FIG. 19, in a possible implementation, the fan 130 further comprises the second fan 132. An air outlet side of the second fan 132 faces towards the circuit board assembly 140. A difference between this solution and the previous solution lies in that an arrangement position of the first fan 131 is different.

In the flowing direction of the cooling airflow, a projection of the second fan 132 at least partially overlaps and the projection of the circuit board assembly 140. Therefore, the second fan 132 can have a good heat dissipation effect on the circuit board assembly 140.

For example, the circulation air duct comprises a plurality of connection sections that are connected in sequence. Two adjacent connection sections have different extending directions. Different fans respectively drive the airflow in different connection sections to flow, to allow the airflow to flow unidirectionally in the circulation air duct. In addition, the first fan 131 and the second fan 132 are respectively located in different connection sections, or the first fan 131 and the second fan 132 are respectively located at opposite ends of a same connection sections, which is not specifically limited in this embodiment of the present disclosure.

It should be noted that the first fan 131 can be configured to assist in forming circulating airflow, and the second fan 132 has a good heat dissipation effect by blowing directly against the circuit board assembly 140. The first fan 131 and the second fan 132 cooperate with each other.

To improve a convenience of maintenance, the box assembly 110 may comprise the box body 111 and the connector 112. The box body 111 has a first opening, and the connector 112 has a second opening. The first opening may be disposed opposite to the second opening. The accommodation cavity 101 is defined by enclosing with the box body 111 and the connector 112. The evaporator 150 may be disposed at the connector 112. The box body 111 may be opened relative to the connector 112, Thus, the integrity of the electronic control box 100 during operating can be ensured through a docking of the box body 111 with the connector 112, while the box body 111 can be opened without disassembling the evaporator 150 during maintenance.

In some embodiment, the evaporator 150 may be fixed at the connector 112. The circuit board assembly 140 is connected to the box body 111. The box body 111 may be detachably connected to the connector 112.

In the air conditioner, the overhaul frequency of the electronic component on the circuit board assembly 140 of the electronic control box 100 is relatively high. It is often necessary to disassemble the electronic control box 100 from a housing of the air conditioner to an outside of the housing to repair the electronic component in the electronic control box 100. In the present disclosure, the evaporator 150 is disposed in the electronic control box, and the evaporator 150 is connected to a flow path of a refrigerant system through a refrigerant pipeline.

When the electronic component in the electronic control box 100 needs to be overhauled, if the electronic control box 100 is completely disassembled outside the housing, the refrigerant pipeline connected to the evaporator 150 needs to be destructively cut off, and a cooling medium in the refrigerant pipeline needs to be recovered. After the overhaul is completed, when the electronic control box 100 is mounted in the housing, the cut refrigerant pipeline needs to be welded again, and such an overhaul process is very complicated.

In the embodiments of the present disclosure, the box assembly 110 in the electronic control box 100 adopts a split design and is divided into different components such as the box body 111 and the connector 112. The electronic component in the electronic control box 100 is disposed in the box body 111. The evaporator 150 is mounted in the connector 112, and the evaporator 150 is connected to the flow path of the refrigerant system through the refrigerant pipeline. The box body 111 and the connector 112 are detachably connected. The connector 112 is fixedly mounted in the air conditioner. The box body 111 can move relative to the connector. In this way, when the electronic components in the electronic control box 100 need to be repaired, the box body 111 and the connector 112 are disassembled to allow the electronic components arranged in the box body 111 to be conveniently inspected or repaired without disassembling the evaporator 150. Therefore, a complicated process of cutting off and re-welding the refrigerant pipeline caused by disassembling the evaporator 150 is avoided, allowing a disassembly process and a mounting process can be relatively simple and easy.

It should be noted that a detachable connection mode between the box body 111 and the connector 112 mainly means that the box body 111 and the connector 112 have variable relative positions. Therefore, the box body 111 and the connector 112 are in a detachable state. The detachable connection mode between the box body 111 and the connector 112 comprises, but is not limited to, the following types.

First type, the box body 111 and the connector 112 can only change a relative position, and are still connected before and after disassembly. A connection mode between the box body 111 and the connector 112 can be, for example, a rotatable connection, or a slidable connection.

Second type, the box body 111 and connector 112 are completely separated in a disassembled state. In this case, the box body 111 and the connector 112 may be connected without any other structure, and a position of the box body 111 can be freely moved relative to the connector 112.

For example, when the electronic control box 100 is applied to the air conditioner, the refrigerant flow path 400 in the air conditioner may be a refrigerant circulation pipeline. The evaporator 150 may be connected to the refrigerant circulation pipeline of the air conditioner, that is, the refrigerant pipeline of the air conditioner may be utilized to serve as the evaporator 150 in the electronic control box 100, thereby achieving the effect of heat exchange. According to an operating principle of the evaporator, a phase change of the refrigerant medium can be utilized to absorb the heat of the cooling airflow 500 in the accommodation cavity 101 to achieve the cooling effect. In addition, the box body 111 can be rotated or pulled open relative to the connector 112 to allow the box body 111 and the evaporator 150 to be separated. Therefore, the evaporator 150 does not need to be disassembled when the components inside the box body 111 are overhauled. That is, the refrigerant does not need to be evacuated to recover the refrigerant, and a connection pipeline between the evaporator 150 and the refrigerant flow path 400 does not need to be disassembled after burning, thereby improving the convenience of the overhaul.

It should be noted that, in the embodiments of the present disclosure, the accommodation cavity 101 may be the sealed accommodation cavity 101. Therefore, internal air of the accommodation cavity 101 may be utilized for circulating heat dissipation, and the electronic control box 100 may not be affected by the external environment to keep the interior clean and dry. Meanwhile, when the accommodation cavity 101 is applied to the outdoor environment, dust and mosquitoes from the outside are prevented from entering the electronic control box 100.

Referring to FIG. 2, the air conditioner comprises the indoor unit 300 and the outdoor unit 200. The outdoor unit 200 is in communication with the indoor unit 300 through the refrigerant pipeline. The compressor 800, the outdoor heat exchanger 210, the electronic expansion valve 700, the indoor heat exchanger, and other components are connected in the refrigerant pipeline. The evaporator 150 in the electronic control box 100 can be connected between the electronic expansion valve 700 and the compressor 800 through the branch pipeline.

Taking a refrigeration process of the air conditioner as an example, the specific process is as follows. The compressor 800 compresses a gaseous refrigerant into a gaseous refrigerant of high temperature and high pressure, and then sends the refrigerant to the outdoor heat exchanger 210 for heat exchange to become a liquid refrigerant of normal temperature and high pressure, allowing the heat of the refrigerant to be transferred to the outside. The liquid refrigerant then enters the evaporator 150 in the electronic control box 100 and the indoor heat exchanger of the indoor unit through the electronic expansion valve 700. The liquid refrigerant vaporizes and becomes a low-temperature gaseous refrigerant, thereby achieving heat exchange and cooling. The refrigerant after heat exchanged is then sent to the compressor 800. In addition, the refrigerant pipeline may further comprise a four-way reversing valve 600 to change the refrigerant flowing direction in the refrigerant pipeline and realize heating of the air conditioner.

As shown in FIG. 1 and FIG. 2, the air conditioner according to the embodiments of the present disclosure may comprise the indoor unit and the outdoor unit 200. The outdoor unit 200 is in communication with all the indoor units 300 through pipelines for flowing heat exchange medium. That is, the outdoor unit 200 and the indoor unit are connected through the refrigerant flow path 400. The electronic control box 100 is disposed in the outdoor unit 200 to control the operation of the air conditioner.

The air conditioner may be a central air conditioner. The indoor units 300 are arranged indoors, and the outdoor unit 200 is disposed outdoors. A plurality of indoor units 300 and a plurality of outdoor units 200 may be provided. The plurality of indoor units 300 may be arranged in one indoor space, or may be arranged in different indoor spaces. The plurality of outdoor units 200 may be equipped with electronic control boxes 100 to control the plurality of outdoor units 200, respectively. The plurality of outdoor units 200 are connected with each other and cooperate with each other to realize multi-master joint operation.

The indoor heat exchanger is usually mounted in an indoor unit of the central air conditioner, and the outdoor heat exchanger is usually mounted in an outdoor unit of the central air conditioner. The indoor heat exchanger and the outdoor heat exchanger are usually connected through refrigerant pipes to allow the refrigerant between the indoor heat exchanger and the outdoor heat exchanger to flow. In a refrigeration process of the central air conditioner, the indoor heat exchanger is the evaporator, and the refrigerant in the evaporator changes from liquid to gas by heat absorption. In a process of refrigerant evaporation and heat absorption, the evaporator exchanges heat with the air flowing through the evaporator. Therefore, heat in air in the indoor unit of the central air conditioner is taken away, and air discharged from the indoor unit of the central air conditioner is the air after heat dissipation and temperature reduction. The indoor unit of the central air conditioning blows cold air. Meanwhile, the outdoor heat exchanger is the condenser, and a refrigerant in the condenser changes from gas to liquid. In a process of condensing and releasing heat of the refrigerant, the condenser exchanges heat with air in the outdoor unit of the central air conditioner flowing through the condenser. Therefore, the air in the outdoor unit of the central air conditioner carries the heat of the condenser to the outside of the outdoor unit of the central air conditioner, thereby realizing the refrigeration process.

In a heating process of the central air conditioner, the outdoor heat exchanger is the evaporator. The refrigerant in the evaporator changes from liquid to gaseous. In the process of refrigerant evaporation and heat absorption, the evaporator exchanges heat with the air flowing through the evaporator, and replaces the heat carried in the air in the outdoor unit of the central air conditioner into the refrigerant in the evaporator. Meanwhile, the indoor heat exchanger is the condenser. The refrigerant in the condenser changes from gaseous to liquid. In the process of condensing and releasing heat of the refrigerant, the condenser exchanges heat with air in the indoor unit of the central air conditioner flowing through the condenser. Therefore, the air in the indoor unit of the central air conditioner takes away the heat carried by the condenser, and is discharged from the indoor unit of the central air conditioner to the room outside the indoor unit of the central air conditioner. In this way, the indoor unit of the central air conditioner blows hot air, realizing the heating process.

The electronic control box may be mounted in the outdoor unit of the central air conditioner. The heat exchanger in the electronic control box may be in communication with a pipeline through which a heat exchange medium of the air conditioner flows. For example, the heat exchanger is connected in parallel or in series with the heat exchanger of the air conditioner. Therefore, the airflow in the electronic control box is refrigerated by utilizing the phase change of the refrigerant of the air conditioner.

In the description of the present disclosure, it should be understood that the orientation or position relationship indicated by the terms such as "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", and "circumferential" should be construed to refer to the orientation or the position as shown in the drawings, and is only for the convenience of describing the present disclosure and simplifying the description, rather than indicating or implying that the pointed apparatus or element must have a specific orientation, or be constructed and operated in a specific orientation, and therefore cannot be understood as a limitation of the present disclosure.

In addition, terms "first" and "second" are only used for descriptive purposes, and cannot be understood as indicating or implying relative importance or implicitly indicating the number of the indicated technical features. Therefore, the features associated with "first" and "second" may explicitly or implicitly comprise at least one of the features. In the description of the present disclosure, "plurality" means at least two, unless otherwise specifically defined.

In the present disclosure, unless otherwise clearly specified and limited, terms such as "install", "connect", "connect to", "fix" and the like should be understood in a broad sense. For example, it may be a fixed connection or a detachable connection or connection as one piece; mechanical connection or electrical connection; direct connection or indirect connection through an intermediate; internal communication of two components or the interaction relationship between two components, unless otherwise clearly limited. For those skilled in the art, the specific meaning of the above-mentioned terms in the present disclosure can be understood according to specific circumstances.

In the present disclosure, unless expressly stipulated and defined otherwise, the first feature "on" or "under" the second feature may mean that the first feature is in direct contact with the second feature, or the first and second features are in indirect contact through an intermediate. Moreover, the first feature "above" the second feature may mean that the first feature is directly above or obliquely above the second feature, or simply mean that the level of the first feature is higher than that of the second feature. The first feature "below" the second feature may mean that the first feature is directly below or obliquely below the second feature, or simply mean that the level of the first feature is smaller than that of the second feature.

In the description of this specification, description with reference to the terms "an embodiment", "some embodiments", "exemplary embodiments", "examples" "specific examples", or "some examples" etc., mean that specific features, structure, materials or characteristics described in conjunction with the embodiment or example are comprised in at least one embodiment or example of the present disclosure. In this specification, the schematic representations of the above terms do not necessarily refer to the same embodiment or example. Moreover, the described specific features, structures, materials or characteristics may be combined in any one or more embodiments or examples in a suitable manner. In addition, without contradicting each other, those skilled in the art may combine and combine different embodiments or examples and features of different embodiments or examples described in this specification.

Although embodiments of the present disclosure have been shown and described above, it should be understood that the above embodiments are merely exemplary, and cannot be construed as limitations of the present disclosure. For those skilled in the art, changes, alternatives, and modifications can be made to the above embodiments without departing from the scope of the present disclosure.

## Claims

1. An air conditioner, comprising a refrigerant flow path and an electronic control box, the electronic control box comprising:
a box assembly having an accommodation cavity;
a circuit board assembly;
a fan generating a cooling airflow in the accommodation cavity; and
an evaporator connected to the refrigerant flow path and refrigerating by means of phase change of a refrigerant, wherein:
each of the circuit board assembly, the fan, and the evaporator is disposed in the accommodation cavity; and
the cooling airflow sequentially flows through the evaporator and the circuit board assembly, the cooling airflow refrigerated by the evaporator dissipating heat from the circuit board assembly.

2. The air conditioner according to claim 1, wherein the evaporator has an inlet connected to a low-pressure liquid refrigerant flow path of the refrigerant flow path, and an outlet connected to a low-pressure gaseous refrigerant flow path of the refrigerant flow path.

3. The air conditioner according to claim 2, wherein:
the circuit board assembly is located between an air outlet of the fan and the evaporator; and
the cooling airflow flows from the fan to the evaporator through the circuit board assembly, or the cooling airflow flows from the fan to the circuit board assembly through the evaporator.

4. The air conditioner according to any one of claims 1 to 3, wherein:
the accommodation cavity has a circulation air duct for unidirectional flow of the cooling airflow, wherein the fan, the circuit board assembly, and the evaporator are sequentially arranged at different positions in the circulation air duct at intervals in a flowing direction of the cooling airflow.

5. The air conditioner according to claim 4, further comprising a separator, wherein:
the separator is disposed in the accommodation cavity; and
the separator divides the accommodation cavity into a first cavity and a second cavity, the first cavity and the second cavity being located at opposite sides of the separator, respectively;
one of two opposite ends of the separator defines a first vent together with an inner wall of the accommodation cavity, and another of the two opposite ends of the separator defines a second vent together with the inner wall of the accommodation cavity, the first cavity and the second cavity being connected end-to-end through the first vent and the second vent.

6. The air conditioner according to claim 5, wherein the circuit board assembly comprises a first circuit module and a second circuit module, power of the first circuit module being greater than power of the second circuit module, one of the first circuit module and the second circuit module being located in the first cavity, another of the first circuit module and the second circuit module being located in the second cavity, and the cooling airflow sequentially flows through the evaporator, the first circuit module, and the second circuit module.

7. The air conditioner according to claim 5, wherein the evaporator is connected between the separator and the inner wall of the accommodation cavity.

8. The air conditioner according to claim 5, wherein the evaporator is sealingly connected to an inner wall of the circulation air duct.

9. The air conditioner according to any one of claims 5 to 8, further comprising a radiator, wherein:
the radiator is constructed to dissipate heat from the circuit board assembly through heat conduction;
the radiator is located between the evaporator and an air inlet of the fan; and
the cooling airflow flows back to the fan through the radiator.

10. The air conditioner according to claim 9, wherein the radiator and the circuit board assembly are located at different sides of the separator.

11. The air conditioner according to claim 10, wherein:
the circuit board assembly is located in the first cavity; and
the radiator is located in the second cavity.

12. The air conditioner according to claim 9, wherein the radiator occupies at least a partial cross-section of the circulation air duct in the flowing direction of the cooling airflow.

13. The air conditioner according to any one of claims 5 to 8, wherein the electronic control box further comprises a heat exchanger assembly, the heat exchanger assembly comprising a heat exchanger and a heat conductor connected to the heat exchanger, wherein:
the heat conductor is located between the circuit board assembly and the heat exchanger and configured to conduct heat from the circuit board assembly to the heat exchanger;
each of the evaporator and the heat exchanger is connected to the refrigerant flow path, the evaporator being configured to refrigerate the airflow passing through the evaporator by means of the phase change of the refrigerant; and
the heat exchanger is configured to refrigerate the circuit board assembly by means of heat exchange between a low-temperature refrigerant and the circuit board assembly through heat conduction.

14. The air conditioner according to claim 13, wherein the heat conductor is connected to the heat exchanger and attached to the circuit board assembly.

15. The air conditioner according to claim 14, wherein the circuit board assembly comprises a circuit board and an electrical element, wherein:
the electrical element being disposed at a same side of the circuit board; and
the heat conductor is attached to a side of the circuit board opposite to the electrical element and disposed opposite to the electrical element.

16. The air conditioner according to claim 13, wherein:
the heat conductor is of a shape of a flat plate; and
the heat conductor has opposite sides attached to circuit board and the heat exchanger, respectively.

17. The air conditioner according to claim 16, wherein the heat exchanger assembly further comprises a support plate, the heat exchanger being mounted at the support plate, and the support plate being attached to the heat conductor.

18. The air conditioner according to claim 17, wherein:
a plate surface area of the support plate is greater than a plate surface area of the heat conductor; and
the heat conductor being attached to a central region of the support plate.

19. The air conditioner according to any one of claims 16 to 18, further comprising a heat exchange fin mounted at the heat exchanger.

20. The air conditioner according to any one of claims 16 to 18, wherein the heat exchanger is a microchannel heat exchanger.

21. The air conditioner according to claim 20, wherein the microchannel heat exchanger is an economizer of the air conditioner.

22. The air conditioner according to any one of claims 5 to 8, wherein the fan comprises a first fan, wherein:
the circuit board assembly is disposed opposite to an air outlet side of the first fan; and
in an airflow flowing direction, a projection of the first fan at least partially overlaps a projection of the circuit board assembly.

23. The air conditioner according to claim 22, wherein:
the evaporator and the first fan are arranged at intervals; and
the circuit board assembly comprises a circuit board and a plurality of electrical elements disposed at the circuit board, the plurality of electrical elements being sequentially arranged between the first fan and the evaporator.

24. The air conditioner according to claim 23, wherein in the airflow flowing direction, projections of at least some of the plurality of electrical elements have an overlap region with a projection of the first fan.

25. The air conditioner according to claim 23 or 24, wherein the fan comprises at least two first fans arranged side-by-side in the circulation air duct in a width direction of the circulation air duct, air outlet sides of the at least two first fans having a same orientation.

26. The air conditioner according to claim 23 or 24, wherein the plurality of electrical elements comprises a reactor, the reactor comprising a first coil,
wherein a connecting line between two ends of the first coil is perpendicular to the flowing direction of the cooling airflow generated by the first fan.

27. The air conditioner according to claim 26, wherein the plurality of electrical elements further comprises a frequency converter module, the reactor and the frequency converter module being arranged in a width direction of the circulation air duct, and each of the reactor and the frequency converter module is disposed opposite to an air outlet of the first fan.

28. The air conditioner according to claim 27, wherein the plurality of electrical elements further comprises a filter module located at a side of the frequency converter module away from the first fan.

29. The air conditioner according to claim 28, wherein the filter module is provided with a filter inductor, the filter inductor having a second coil,
wherein a radial direction of the second coil is parallel to the flowing direction of the cooling airflow generated by the first fan.

30. The air conditioner according to claim 28 or 29, wherein the plurality of electrical elements comprises a main control board and a terminal block that are both located at a side of the filter module away from the first fan.

31. The air conditioner according to claim 23 or 24, wherein the fan further comprises a second fan, an air outlet side of the second fan facing towards the circuit board assembly.

32. The air conditioner according to claim 31, wherein in the airflow flowing direction, a projection of the second fan at least partially overlaps the projection of the circuit board assembly.

33. The air conditioner according to claim 32, wherein:
the circulation air duct comprises a plurality of connection sections connected in sequence, two adjacent connection sections of the plurality of connection sections having different extending directions; and
different fans respectively drive the cooling airflow in different connection sections of the plurality of connection sections to flow, the cooling airflow flowing unidirectionally in the circulation air duct.

34. The air conditioner according to claim 33, wherein:
the first fan and the second fan are located in different connection sections of the plurality of connection sections, respectively; or
the first fan and the second fan are located at opposite ends of the connection section, respectively.

35. The air conditioner according to any one of claims 5 to 8, wherein the fan and the evaporator are located at two ends of the separator, respectively.

36. The air conditioner according to any one of claims 5 to 8, wherein the fan and the evaporator are located at one end of the separator.

37. The air conditioner according to any one of claims 5 to 8, wherein:
the separator extends in a vertical direction;
the cooling airflow flows in the vertical direction in the first cavity and the second cavity; and
a flowing direction of the cooling airflow in the first cavity is opposite to a flowing direction of the cooling airflow in the second cavity.

38. The air conditioner according to any one of claims 1 to 3, wherein the box assembly comprises a box body and a connector, wherein:
the box body has a first opening;
the connector has a second opening disposed opposite to the first opening;
the accommodation cavity is defined by enclosing with the box body and the connector; and
the evaporator being disposed at the connector.

39. The air conditioner according to claim 38, wherein:
the evaporator is fixed at the connector;
the circuit board assembly is connected to the box body; and
the box body is detachably connected to the connector.

40. The air conditioner according to any one of claims 1 to 3, wherein the accommodation cavity is a sealed accommodation cavity.

41. The air conditioner according to any one of claims 1 to 3, comprising an indoor unit and an outdoor unit connected to the indoor unit, the electronic control box being disposed in the outdoor unit.
